(19) Europäisches Patentamt
European Patent Office
Office européen des brevets

(11) EP 1 346 843 A1

(12) **EUROPEAN PATENT APPLICATION**

(43) Date of publication:
**24.09.2003 Bulletin 2003/39**

(51) Int Cl.[7]: **B41M 5/36**, B41C 1/10, G03F 7/32

(21) Application number: **03006248.3**

(22) Date of filing: **20.03.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **22.03.2002 JP 2002080852**

(71) Applicant: **Fuji Photo Film Co., Ltd.**
**Kanagawa-ken (JP)**

(72) Inventor: **Nagase, Hiroyuki,**
**Fuji Photo Film Co., Ltd.**
**Haibara-gun, Shizuoka-ken (JP)**

(74) Representative: **Grünecker, Kinkeldey,**
**Stockmair & Schwanhäusser Anwaltssozietät**
**Maximilianstrasse 58**
**80538 München (DE)**

# (54) Image forming method

(57) An image forming method using a negative type image forming material is disclosed, and said method comprises the steps of exposing a negative type image forming material to infrared laser imagewise, which image forming material comprises a substrate and an image recording layer formed thereon, comprising (A) a radical generator, (B) a radical-polymerizable compound, (C) an infrared absorbing agent, and (D) a binder polymer; and developing the image forming material with an alkaline developing solution comprising a weak acid or a salt thereof having a dissociation constant pka of from 10 to 13.

EP 1 346 843 A1

## Description

FIELD OF THE INVENTION

The present invention relates to an image forming method using a negative type image forming material, capable of achieving direct plate making, that is, making a printing plate directly by exposing the image forming material to infrared laser scanning based on digital signals from computers or the like.

BACKGROUND OF THE INVENTION

A recent development in the field of lasers has been significant, and in particular, it has become easy to obtain high-powered, small-sized laser devices that can emit light of wavelengths ranging from a near infrared region to an infrared region. Such laser devices are remarkably useful as light sources for recording in "computer-to-plate" technology, which will be hereinafter referred to as "CTP", which allows the transfer of digital data from computers or the like directly to image forming materials so as to make printing plates. For example, currently available solid lasers and semiconductor lasers capable of infrared radiation within a wavelength range from 760 to 1200 nm have the advantage of very high output power within the above-mentioned wavelength range. In recent years, therefore, there is an increasing demand for an image forming material that has high sensitivity to such lasers, namely, that can greatly change its solubility in a developing solution after exposed to such lasers.

As such an image forming material recordable with infrared lasers, an image forming material capable of inducing radical addition polymerization is conventionally proposed. Typically, image formation can be achieved by imagewise exposing the image forming material to laser light, and developing the image forming material using an alkaline aqueous solution. In such an image formation process, there are two methods: one is to conduct a heat treatment after irradiation of the laser beam, and the other is to start the development immediately after the light exposure without any heat treatment. The former has the shortcomings that a system to carry out the method tends to increase in size and cost because installation of a heating oven is required in an automatic processor for development. On the other hand, one major drawback to the latter method, i.e., non-heating method is that the radical polymerization cannot be accelerated because of the absence of a heating step. As a result, portions exposed to the laser beams cannot be cured sufficiently, so that the printing durability of printing plates made by the latter method is inferior to that by the former method including the heating step. However, the fact that there is no need to set a heating oven in the latter method brings about significant advantages to the users, so that an improved non-heating method has been expected.

To impart sufficient printing durability to the printing plate made by the non-heating method, it is desired to minimize the damage to be applied to image portions in the image forming material in the course of development. For instance, JP KOKAI No. Hei 8-108621 discloses a negative type image forming material comprising a photopolymerizable composition, which is used in combination with a strong alkaline aqueous solution with a pH value of 12.5 or more containing, for example, potassium silicate. Such a developing solution of high pH value tends to impair the image portions formed in the image forming material, which will unfavorably lower the printing durability of the printing plate to be obtained. In addition, there is a drawback that components constituting the image forming material are accumulated and deposited on a developer tank during repeated operations for a long time, thereby clogging the valves or the like.

WO 00/48836 discloses a negative type image forming material comprising a photopolymerizable composition, which image forming material is used in combination with an alkaline aqueous solution containing an alkali such as diethanolamine. This type of developing solution containing an amine such as diethanolamine shows a relatively low pH value, so that the developing solution absorbs less carbon dioxide contained in the air when set in the automatic processor. The result is that variation in the activity of the developing solution with time can be minimized. However, this developing solution is poor in the buffering action thereof and therefore, there is a problem that the pH value of the developing solution is easy to vary in the course of development procedure.

When compared with a photopolymerizable-type plate material, a thermally polymerizable-type image forming material which is imageable therein by an infrared laser is susceptible to variation of pH value of the developing solution during development, because curing of the image surface portion of the latter material is a main action and curing of the internal portion thereof is relatively insufficient. Furthermore, when the heat treatment is not employed during a plate making process, curing of the light-exposed portion less proceeds than in case that the heat treatment is employed, and image-forming properties is susceptible to damage due to variation of activity in the developing solution. Even if the pH value of the developing solution undergoes a change slightly, it results that the resolution of image and the printing durability of the plate obtained are affected.

Thus, in case that an image forming material capable of recording images therein by irradiation of infrared laser is used to make a lithographic printing plate, it is desired to use a developing solution which has a relatively low pH value, which developing solution being capable of reducing damage to the image areas and developing the non-image areas sufficiently, and there is in need of a developing solution which is less changeable in a pH value thereof, i.e., has high stability of pH value thereof, in order to provide a lithographic printing plate of stable quality.

SUMMARY OF THE INVENTION

Accordingly, it is an object of the present invention to provide an image forming method using a negative type image forming material capable of recording images therein by irradiation of infrared laser, wherein an image area to be formed in the image forming material can exhibit sufficient strength and excellent resolution even though any heat treatment is not carried out after the irradiation of infrared laser. To be more specific, the object of the present invention is to provide the image forming method capable of imparting excellent printing durability and high resolution to the image portion formed in the image forming material although the method does not include any heat treatment after light exposure; and making stably a lithographic printing plate of high quality through a development processing procedure with a constant sdeveloping solution activity.

The inventor of this invention has conducted various studies, and found that an inclusion of a weak acid or a salt thereof having a dissociation constant pka of from 10 to 13 into a developing solution is effective in suppressing the pH change of the developing solution, and exhibiting and assuring sufficient development performance without scumming in a plate obtained, even if the developing solution has a relatively low pH value. The present invention has been thus accomplished.

Namely, the present invention provides an image forming method comprising the steps of exposing a negative type image forming material to infrared laser imagewise, which image forming material comprises a substrate and an image recording layer formed thereon, comprising (A) a radical generator, (B) a radical-polymerizable compound, (C) an infrared absorbing agent, and (D) a binder polymer; and developing the image forming material with an alkaline developing solution comprising a weak acid or a salt thereof having a dissociation constant pka of from 10 to 13.

In one embodiment of the present invention, the alkaline developing solution used has a pH value ranging from 9.0 to 12.0. In a preferable embodiment of the present invention, the alkaline developing solution used comprises a nonionic surfactant and/or an anionic surfactant in the amount of from 0.1 to 20% by weight. In one embodiment of the present invention, the alkaline developing solution used comprises a chelating agent.

DETAILED DESCRIPTION OF THE INVENTION

Hereinafter the image forming method according to the present invention will be explained in detail. Firstly, the alkaline developing solution used in the present invention will be explained.

The alkaline developing solution used in the present invention is an aqueous solution comprising a base or bases, and the pH value thereof is generally from 9.0 to 12.0, and preferably from 9.5 to 11.0.

[Weak Acid or Salt thereof having Dissociation Constant pka of from 10 to 13]

A weak acid or a salt thereof having a dissociation constant pka ranging from 10 to 13 used in the present invention may be selected from those described in "IONISATION CONSTANTS OF ORGANIC ACIDS IN AQUEOUS SOLUTION" published by Pergamon Press, and includes alcohols such as 2,2,3,3-tetrafluoropropanol-1 (pka: 12.74), trifluoroethanol (pka: 12.37) and trichloroethanol (pka: 12.24), aldehydes such as pyridine-2-aldehyde (pka:12.68) and pyridine-d-aldehyde (pka: 12.05), a compound having a phenolic hydroxyl group such as salicylic acid (pka: 13.0), 3-hydroxy-2-naphthoic acid (pka: 12.8), catechol (pka: 12.6), gallic acid (pka: 12.4), sulfosalicylic acid (pka: 11.7), 3,4-dihydroxysulfonic acid (pka: 12.2), 3,4-dihydroxybenzoic acid (pka: 11.94), 1,2,4-trihydroxybenzen (pka: 11.82), hydroquinone (pka:11.56), pyrogallol (pka: 11.34), o-cresol (pka: 10.33), resorcinol (pka: 11.27), p-cresol (pka: 10.27) and m-cresol (pka: 10.09), sugars such as sorbitol (pka: 13.0), sucrose (pka: 12.7), glucose (pka: 12.46) and L-ascorbic acid (pka: 11.34), oximes such as 2-butanoneoxime (pka: 12.45), acetoxime (pka: 12.42), 1,2-cycloheputadione dioxime (pka: 12.3), 2-hydroxybenzaldehyde oxime (pka: 12.10), dimethylglyoxime (pka: 11.9), ethanediamide dioxime (pka: 11.37) and acetophenone oxime (pka: 11.35), a nucleic acid related compound such as adenosine (pka: 12.56), inosine (pka: 12.5), guanine (pka: 12.3), cytosine (pka: 12.2), hypoxanthine (pka: 12.1) and xanthine (pka: 11.9), and others such as diethylaminomethylphosphonic acid (pka: 12.32), 1-amino-3,3,3-trifluorobenzoic acid (pka: 12.29), isopropylidene diphosphonic acid (pka: 12.10), 1,1-ethylidene diphosphonic acid (pka: 11.54), 1,1-ethylidene diphosphonic acid 1-hydroxy (pka: 11.52), benzimidazole (pka: 12.86), thiobenzamide (pka: 12.8), picoline thioamide (pka: 12.55), barbituric acid (pka: 12.5), and weak acids such as phosphoric acid (pka: 12.4), metasilicic acid (pka: 12.0), orthosilicic acid (pka: 12.0), arsenic acid (pka: 11.5), hydrogen peroxide (pka: 11.6), hydrogen sulfide (pka: 11.9) and carbonic acid (pka: 10.33).

Among these, preferred are sulfosalicylic acid, phosphoric acid, inosine, acetoxime and sucrose. The salt of weak acid includes alkaline metal salts such as a sodium salt, a potassium salt and a lithium salt. The weak acid or the salt thereof may be used alone or in any combination of at least two of them. The amount of the weak acid and/or the salt thereof in the developer ranges generally from 0.01 to 1 mole/liter.

[Alkaline Agent]

The alkaline agent which is usable in combination with the above weak acid or a salt thereof includes sodium hydroxide, ammonium hydroxide, potassium hydroxide, and lithium hydroxide. Others include sodium tertiary phosphate, potassium tertiary phosphate, ammonium tertiary phosphate, sodium borate, potassium borate, and ammonium borate. The alkaline agent which is usable also includes organic alkaline agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, tetramethylammonium hydroxide and the like. The alkaline agent may be used alone or in any combination.
The alkaline agent may be used in a concentration and a combination which are selected so as to adjust preferably a pH value of the developing solution.
The alkaline developing solution may comprise diverse surfactants such as a nonionic surfactant, an anionic surfactant and an amphoteric surfactant.

[Nonionic Surfactant]

A nonionic surfactant which is suitably used includes a nonionic surfactant having an aromatic ring, and such a surfactant includes a compound represented by the following formula:

X-Y-O-(A)n-(B)m-H

wherein X is an aromatic ring; Y represents a single bond or an alkylene group having 1 to 10 carbon atoms; A and B, which are different from each other, represent $-CH_2CH_2O-$ or $-CH_2CH(CH_3)O-$; and n and m each represent 0 or an integer of from 1 to 100, provided that n and m are not 0 at the same time.
In the compound of the above formula, the aromatic group represented by X in the formula includes phenyl, naphthyl, and anthranyl groups. These aromatic groups may have a substituent. In the formula, when both A and B exist, they may be arrayed in the form of a random or block copolymer.
The compound represented by the above formula includes the compounds represented by the following formula (I-A) or (I-B).

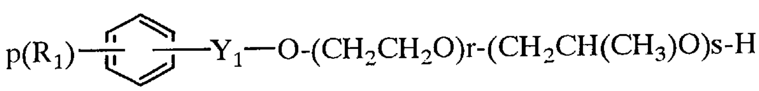

(I-A)

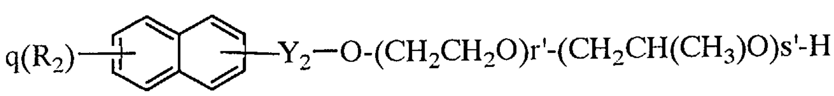

(I-B)

wherein $R_1$ and $R_2$ each represents hydrogen atom or an organic residue having 1 to 100 carbon atoms; p and q each represents an integer of 1 or 2, $Y_1$ and $Y_2$ each represents a single bond or an alkylene group having 1 to 10 carbon atoms; r and s each represents 0 or an integer ranging from 1 to 100 provided that r and s are not zero at the same time; r' and s' each represents 0 or an integer ranging from 1 to 100 provided that r' and s' are not zero at the same time. In the formula (I-A), when p is 2 and $R_1$ represents an organic residue, two of $R_1$ may be the same or different and two of $R_1$ together may form a ring. In the formula (II-B), when q is 2 and $R_2$ represents an organic residue, two of $R_2$ may be the same or different and two of $R_2$ together may form a ring.
The above organic residue having 1 to 100 carbon atoms represented by $R_1$ and $R_2$ includes aliphatic hydrocarbon groups which may be saturated or unsaturated, and may be in the form of linear or branched chain, and aromatic hydrocarbon groups, such as alkyl, alkenyl, alkynyl, aryl and aralkyl groups. Other examples of such organic residue are alkoxy, aryloxy, N-alkylamino, N,N-dialkylamino, N-arylamino, N,N-diarylamino, N-alkyl-N-arylamino, acyloxy, carbamoyloxy, N-alkylcarbamoyloxy, N-arylcarbamoyloxy, N,N-dialkylcarbamoyloxy, N,N-diarylcarbamoyloxy, N-alkyl-N-arylcarbamoyloxy, acylamino, N-alkylacylamino, N-arylacylamino, acyl, alkoxycarbonylamino, alkoxycarbonyl, aryloxycarbonyl, carbamoyl, N-alkylcarbamoyl, N,N-dialkylcarbamoyl, N-arylcarbamoyl, N,N-diarylcarbamoyl, N-alkyl-N-arylcarbamoyl, polyoxyalkylene groups, the above exemplified organic residue to which a polyoxyalkylene group bonds, and the like. The above "alkyl" may be in the form of linear or branched chain.

Preferred examples of $R_1$ and $R_2$ are hydrogen atom; linear or branched alkyl group having 1 to 10 carbon atoms; alkoxy group, alkoxycarbonyl group, N-alkylamino group, N,N-dialkylamino group, N-alkylcarbamoyl group, acyloxy group and acylamino group which have 1 to 10 carbon atoms; polyoxyalkylene group wherein the number of repeating unit is from 5 to 20; aryl group having 6 to 20 carbon atoms; and the aryl group to which a polyoxyalkylene group bonds with the number of repeating unit being from 5 to 20.

In the compound represented by the formula (I-A) or (I-B), the number of repeating unit in the polyoxyethylene chain is preferably from 3 to 50, and more preferably from 5 to 30. The number of repeating unit in the polyoxypropylene chain is preferably from 0 to 10, more preferably from 0 to 5. In the compound represented by the formula (I-A) or (I-B), the polyoxyethylene moiety and the polyoxypropylene moiety may be arrayed in the form of random or block copolymer.

Examples of the compound represented by the formula (I-A) include polyoxyethylene phenylether, polyoxyethylene methylphenylether, polyoxyethylene octylphenylether and polyoxyethylene nonylphenylether. Examples of the compound represented by the formula (I-B) include polyoxyethylene naphthylether, polyoxyethylene methylnaphthylether, polyoxyethylene octylnaphthylether and polyoxyethylene nonylnaphthylether.

The nonionic surfactant may be used alone or in any combination of at least two of them in the developing solution.

Specific examples of the compound represented by the formula (I-A) or (I-B) are shown below.

Y-1

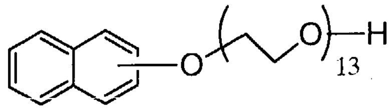

Y-2

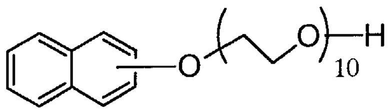

Y-3

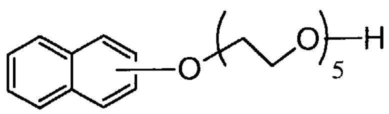

Y-4

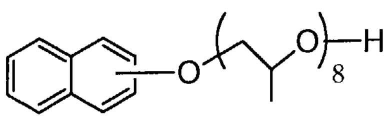

Y-5

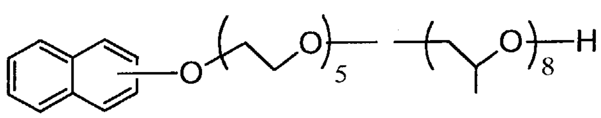

Y-6

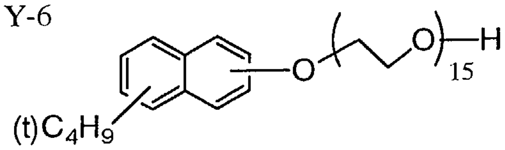

Y-7

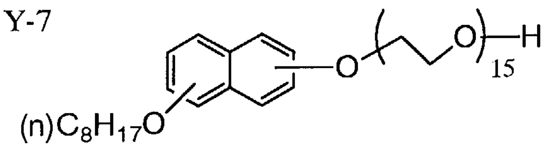

Y-8

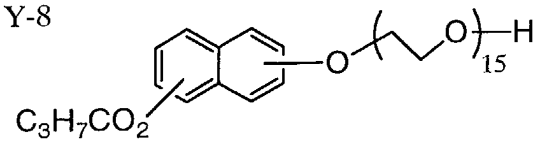

Y-9

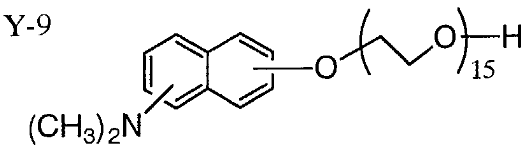

Y-10

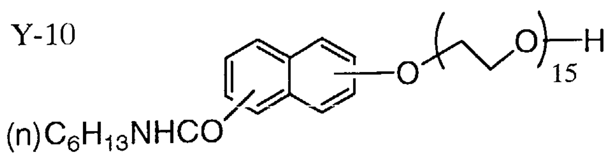

Y-11

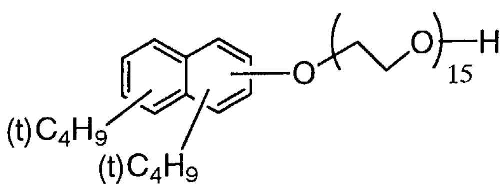

Y-12

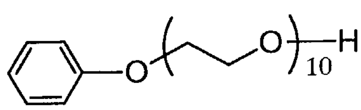

Y-13

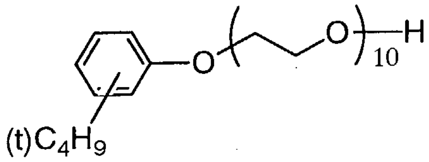

Y-14

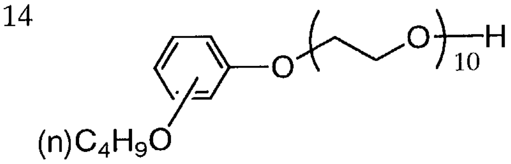

Y-15

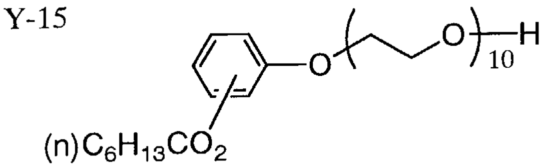

Y-16

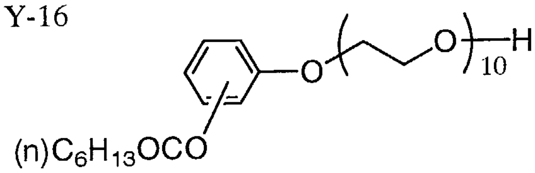

Y-17

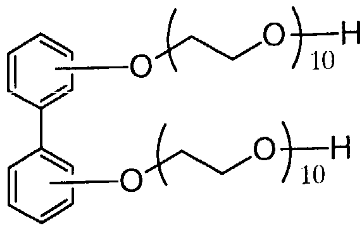

Y-18

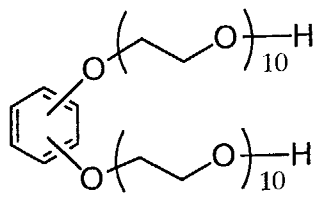

Y-19

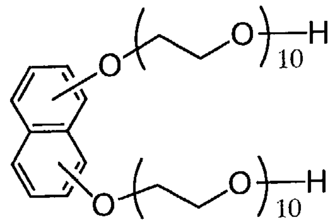

Y-20

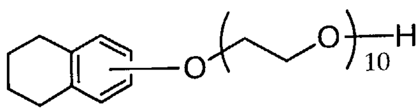

Y-21

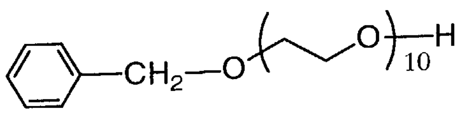

Y-22

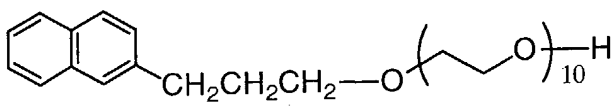

Other examples of a nonionic surfactant which is usable include polyoxyethylene alkyl ethers such as polyoxyethylene lauryl ether, polyoxyehtylene cetyl ether and polyoxyethylene stearyl ether, polyoxyethyelene alkylaryl ethers such as polyoxyethylene octylphenyl ether and polyoxyethylene nonylphenyl ether, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquioleate and sorbitan trioleate, and monoglyceride alkyl esters such as glycerol monostearate and glycerol monooleate.

[Anionic Surfactant]

An anionic surfactant which is suitably used includes alkylbenzene sulfonic acid salts such as sodium dodecylbenzenesulfonate; alkylnaphthalene sulfonic acid salts such as sodium butylnaphthalenesulfonate, sodium pentylnaphthalenesulfonate, sodium hexylnaphthalenesulfonate and sodium octylnaphthalenesulfonate; alkylsulfuric acid salts such as dodecyl sodium sulfate; alkyl sulfonic acid salts such as sodium dodecylsulfonate; and sulfosuccinate salts such as dilauryl sodium sulfosuccinate.

An amphoteric surfactant is also usable, including alkylbetaines such as laurylbetaine and stearylbetaine; and amino acids type-amphoteric surfactants.

In the alkaline developing solution used in the present invention, the surfactant may be used alone or in any combination of at least two of them. Preferred among these are a nonionic surfactant and/or an anionic surfactant. The amount of the surfactant in the developing solution ranges generally from 0.1 to 20% by weight, and preferably from 2 to 10% by weight in terms of the effective component thereof.

(Chelating Agent)

The developing solution used in the present invention may comprise a chelating agent. Such chelating agent includes polyphosphates such as $Na_2P_2O_7$, $Na_5P_3O_3$, $Na_3P_3O_9$, $Na_2O_4P(NaO_3P)PO_3Na_2$ and Calgon (trade name of sodium polymetaphosphate, available from Calgon Inc, (USA)); polyaminocarboxylic acids and salts thereof such as ethylenediaminetetraacetic acid and potassium and sodium salts thereof, diethylenetriaminepentaacetic acid and potassium and sodium salts thereof, triethylenetetraminehexaacetic acid and potassium and sodium salts thereof, hydroxyethylethylenediaminetriacetic acid and potassium and sodium salts thereof, nitrilotriacetic acid and potassium and sodium salts thereof, 1,2-diaminocyclohexanetetraacetic acid and potassium and sodium salts thereof and 1,3-diamino-2-propanoltetraacetic acid and potassium and sodium salts thereof; and organophosphonic acids, potassium, sodium and ammonium salts thereof such as 2-phosphonobutane tricarboxylic acid-1,2,4 and potassium and sodium salts thereof, 2-phosphonobutanone tricarboxylic acid-2,3,4 and potassium and sodium salts thereof, 1-phosphonoethane tricarboxylic acid-1,2,2 and potassium and sodium salts thereof, 1-hydroxyethane-1,1-diphosphonic acid and potassium and sodium salts thereof and amino tri(methylene phosphonic acid) and potassium and sodium salts thereof. The optimum amount of the chelating agent varies depending on the hardness and the amount of hard water used, but the amount thereof in general ranges from 0.01 to 5% by weight and preferably 0.01 to 0.5% by weight in the developing solution practically used.

(Others)

The developing solution used in the present invention may further comprise as occasion demands, other components than those described above. Such components include organic carboxylic acids such as benzoic acid, phthalic acid, p-ethyl benzoic acid, p-n-propyl benzoic acid, p-isopropyl benzoic acid, p-n-butyl benzoic acid, p-t-butyl benzoic acid, p-2-hydroxyethyl benzoic acid, decanoic acid, salicylic acid, 3-hydroxy-2-naphthoic acid and the like; organic solvents such as isopropyl alcohol, benzyl alcohol, ethyl cellosolve, butyl cellosolve, phenyl cellosolve, propylene glycol, diacetone alcohol and the like; a reducing agent; a colorant dye; a pigment; a water softner; an antiseptic agent and the like.

The above mentioned developing solution can be used as a developing solution or a replenisher for development of a negative type image forming material, and is preferably applied to an automatic processor. When an automatic processor is used to perform development procedure, the developing solution becomes exhausted depending on throughput amount of materials processed, and a replenisher or a flesh developing solution may be used to restore the throughput capacity of developing solution. Specifically, when a replenisher which has the higher concentration of a bicarbonate than those in an initial developing solution is supplied to the developing solution, the more amount of image forming material can be processed with no need to exchange of the developing solution in a developer tank for a long period of time. This manner of using the replenisher may be preferably applied to the image forming method of the present invention.

An image forming material for use with the image forming method of the present invention comprises a substrate and an image recording layer formed thereon, comprising (A) a radical generator, (B) a radical-polymerizable compound, (C) an infrared absorbing agent, and (D) a binder polymer. When such an image forming material is imagewise exposed to infrared laser beams, one portion of the image recording layer exposed to the infrared laser absorbs the laser light and convert light into heat energy owing to the function of the infrared absorbing agent (C) contained in the image recording layer. By the application of heat thus generated, the radical generator (A) also contained in the image recording layer is decomposed to generate radicals, which induce a reaction of the radical-polymerizable compound (B) and the binder polymer (D). The above-mentioned light-exposed portion is thus cured to be an image area. The other portion not exposed to infrared laser beams is not cured, so that the non-cured portion is removed from the image forming material when the image forming material is developed with the previously mentioned alkaline developing solution. The latter portion becomes a non-image area.

Each of the components constituting the image recording layer will now be explained in detail.

(A) Radical generator

The radical generator for use in the present invention is a compound that can generate radicals upon irradiation of infrared laser, when used in combination with the infrared absorbing agent (C). Examples of the radical generator include onium salts, s-triazine compounds having a trihalomethyl group, peroxides, azo based polymerization initiators, azido compounds, and borate salts. In particular, the onium salts are preferable because they have high sensitivity. Specific examples of the onium salts are iodonium salts, diazonium salts, and sulfonium salts. These onium salts do not serve as an acid generator, but a radical polymerization initiator.

Among the above-mentioned onium salts which are suitably used in the present invention are the following

onium salts represented by formulas (1) to (3).

(1) $Ar^{11}-\overset{+}{I}-Ar^{12}\quad Z^{11-}$

(2) $Ar^{21}-\overset{+}{N}\equiv N\quad Z^{21-}$

(3) 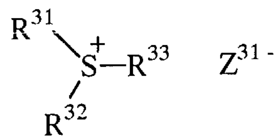

In the above formula (1), $Ar^{11}$ and $Ar^{12}$ are each independently an aryl group having 20 carbon atoms or less which may have a substituent. Preferable examples of the substituent for the aryl group include a halogen atom, nitro group, an alkyl group having 12 carbon atoms or less, an alkoxyl group having 12 carbon atoms or less, and an aryloxy group having 12 carbon atoms or less. $Z^{11-}$ represents a counter ion such as a halogen ion, perchlorate ion, tetrafluoroborate ion, carboxylate ion, hexafluorophosphate ion, or sulfonate ion. Preferably used are perchlorate ion, carboxylate ion, and arylsulfonate ion.

In the above formula (2), $Ar^{21}$ is an aryl group having 20 carbon atoms or less which may have a substituent. Preferable examples of the substituent for the aryl group include a halogen atom, nitro group, an alkyl group having 12 carbon atoms or less, an alkoxyl group having 12 carbon atoms or less, an aryloxy group having 12 carbon atoms or less, an alkylamino group having 12 carbon atoms or less, a dialkylamino group having 12 carbon atoms or less, an arylamino group having 12 carbon atoms or less, and a diarylamino group having 12 carbon atoms or less. $Z^{21-}$ represents the same counter ion as previously defined in $Z^{11-}$.

In the above formula (3), $R^{31}$, $R^{32}$, and $R^{33}$, which may be the same or different, are each a hydrocarbon group having 20 carbon atoms or less which may have a substituent. Preferable examples of the substituent for the hydrocarbon group include a halogen atom, nitro group, an alkyl group having 12 carbon atoms or less, an alkoxyl group having 12 carbon atoms or less, and an aryloxy group having 12 carbon atoms or less. $Z^{31-}$ represents the same counter ion as previously defined in $Z^{11-}$.

Specific examples of the onium salts preferably used in the present invention are shown below.

[ OI-1 ] 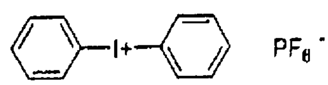

[ OI-2 ] 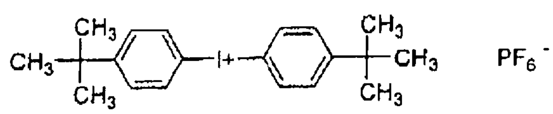

[ OI-3 ] 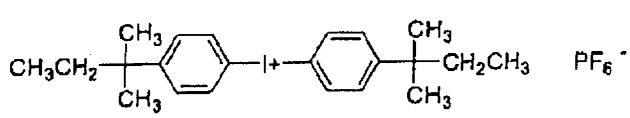

[ OI-4 ]

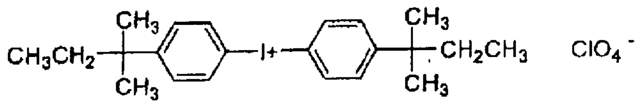

[ OI-5 ]

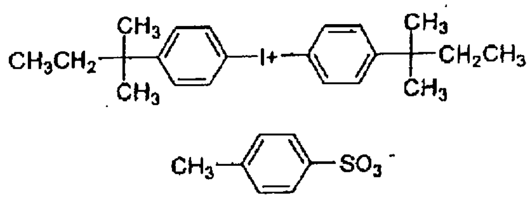

[ OI-6 ]

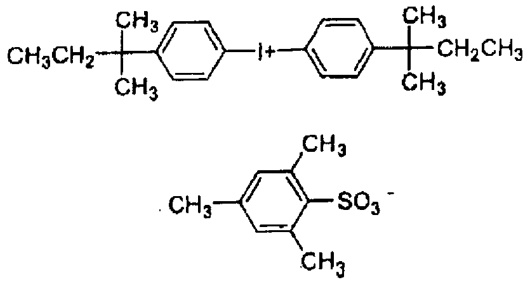

[ OI-7 ]

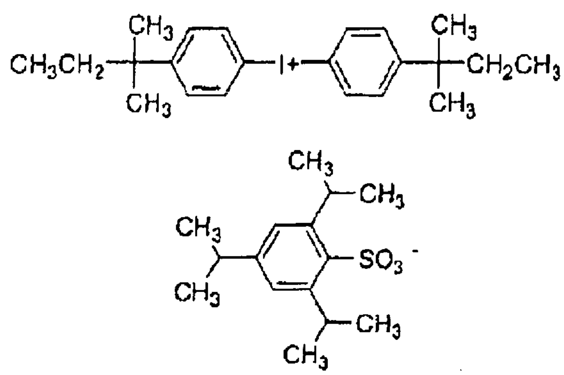

[ OI-8 ] 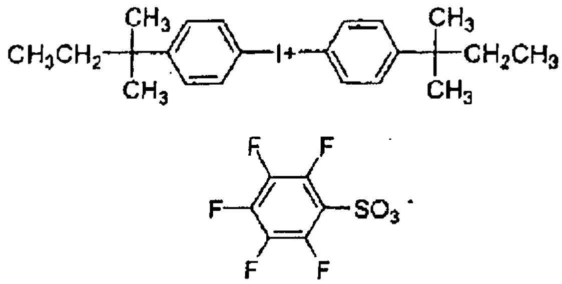

[ OI-9 ] 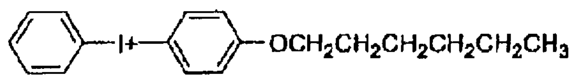

[ OI-10 ] 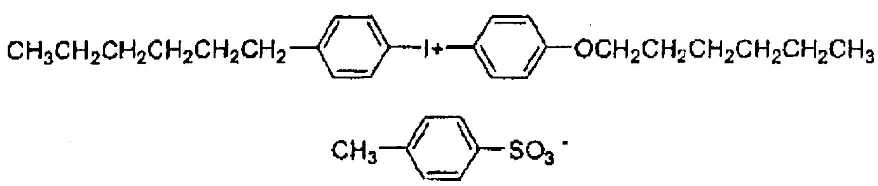

[ ON-1 ] 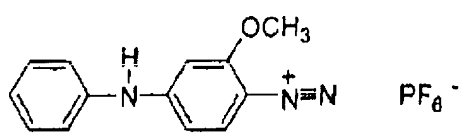

[ ON-2 ] 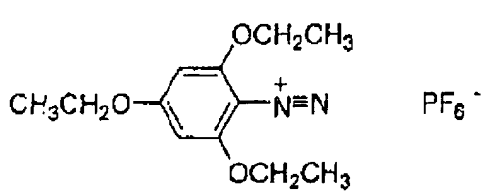

[ ON-3 ]

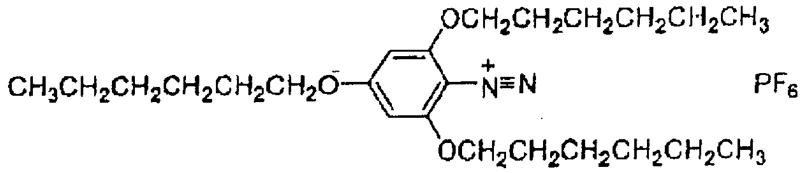

$PF_6^-$

[ ON-4 ]

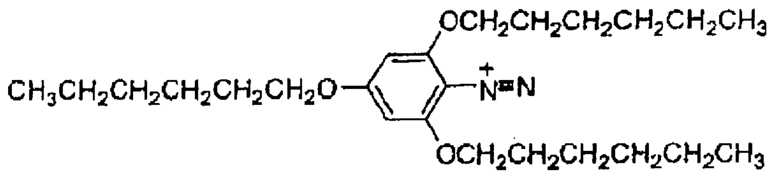

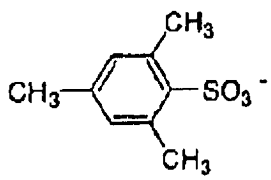

[ ON-5 ]

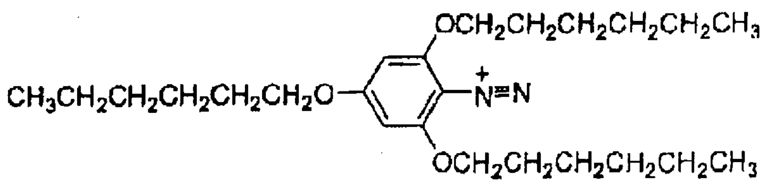

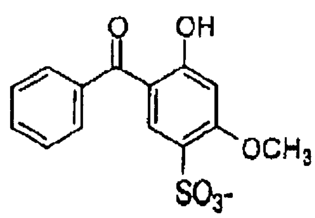

[ OS-1 ]

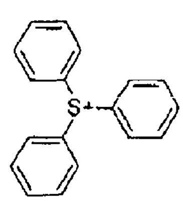

$ClO_4^-$

[ OS-2 ]

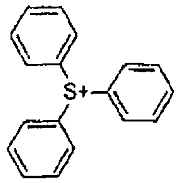

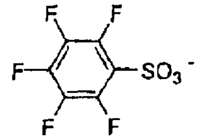

[ OS-3 ]

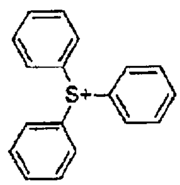

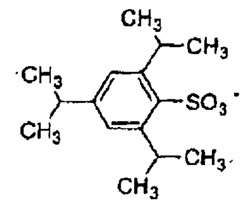

[ OS-4 ]

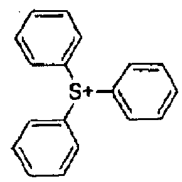

$CF_3SO_3^-$

[ OS-5 ]

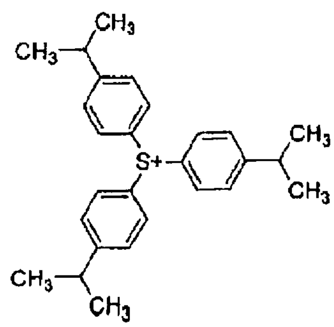

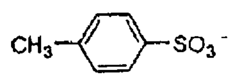

[ OS-6 ]

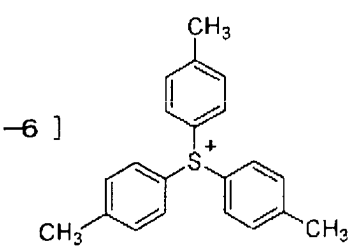

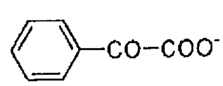

[ OS-7 ]

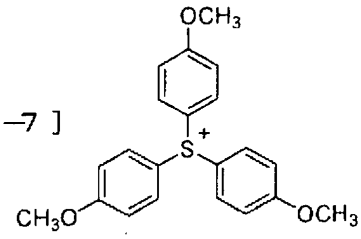

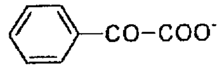

[ OS-8 ]

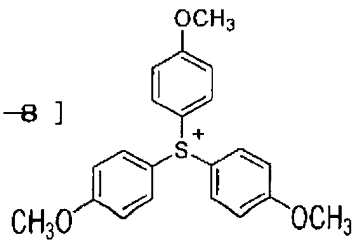

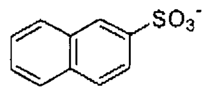

It is preferable that the radical generator for use in the present invention have a maximum absorption wavelength of 400 nm or less, and more preferably 360 nm or less. When the radical generator for use in the image recording layer exhibits an absorption wavelength within the ultraviolet region, the image forming material can be handled under white light.

The amount of the radical generator is suitably in the range of 0.1 to 50% by weight, preferably 0.5 to 30% by weight, and more preferably 1 to 20% by weight, based on a total solid content of a coating liquid for the image recording layer. When the amount of the radical generator is less than 0.1% by weight, the sensitivity is lowered. On the other hand, when the amount of the radical generator exceeds 50% by weight, a non-image area is contaminated during printing. The above-mentioned radical generators may be used alone or in combination. Further, the radical generator may be contained in a single image recording layer together with other components. Alternatively, the image forming material may further comprise an additional layer where the radical generator is contained.

(B) Radical-polymerizable compound

The radical-polymerizable compound for use in the present invention is a compound having at least one ethylenically unsaturated double bond, which compound is selected from the compounds having at least one, preferably two or more terminal ethylenically unsaturated double bonds. Such compounds are well known in the art, and any compounds can be used in the present invention without any limitation. The radical-polymerizable compound is in the form of a monomer, prepolymer, that is, a dimmer, trimer or oligomer, a mixture thereof, or a copolymer of the above monomers. Examples of such monomers and copolymers of the monomers include unsaturated carboxylic acids such as acrylic acid, methacrylic acid, itaconic acid, crotonic acid, isocrotonic acid, and maleic acid, and esters and amides thereof. Preferably used are ester compounds of an unsaturated carboxylic acid and an aliphatic polyhydric alcohol and amide compounds of an unsaturated carboxylic acid and an aliphatic polyvalent amine. In addition, also preferably used are an unsaturated carboxylic acid ester having a nucleophilic substituent such as a hydroxyl group, an amino group or a mercapto group or the like; an addition reaction product of amides and monofunctional or polyfunctional isocyanates, or epoxys; a dehydration condensation reaction product of amides and a monofunctional or polyfunctional carboxylic acid and the like. Further, as the preferable radical-polymerizable compounds, there can be mentioned an addition reaction product of an unsaturated carboxylic acid esters or amides having an electrophilic sugstituent, such as an isocyanate group or an epoxy group, and monofunctional or polyfunctional alcohols, amines or thiols, and further, a substitution reaction product of an unsaturated carboxylic acid esters or amides having an elimination substituent such as a halogen group or a tosyloxy group and a monofunctional or polyfunctional alcohols, amines or thiols. Similarly, the reaction products obtained by using unsaturated phosphonic acid or styrene instead of the above-mentioned unsaturated carboxylic acid can also be used.

Specific examples of the esters of aliphatic polyhydric alcohol compounds and unsaturated carboxylic acids,

which constitute a group of preferable radical-polymerizable compounds, are as follows:

acrylic esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomer;

methacrylic esters such as tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane;

itaconates such as ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate;

crotonates such as ethylene glycol dicrotonate, tetramethylene glycol dicrotonate, pentaerythritol dicrotonate, and sorbitol tetradicrotonate;

isocrotonates such as ethylene glycol diisocrotonate, pentaerythritol diisocrotonate, and sorbitol tetraisocrotonate; and

maleates such as ethylene glycol dimaleate, triethylene glycol dimaleate, pentaerythritol dimaleate, and sorbitol tetramaleate.

Other examples of the esters include aliphatic alcohol based esters as disclosed in JP KOKOKU No. Sho 46-27926, JP KOKOKU No. Sho 51-47334, and JP KOKAI No. Sho 57-196231; esters with an aromatic skeleton as disclosed in JP KOKAI No. Sho 59-5240, JP KOKAI No. Sho 59-5241, and JP KOKAI No. Hei 2-226149; and amino-group containing esters as disclosed in JP KOKAI No. Hei 1-165613.

Examples of the above-mentioned amide monomers prepared from the aliphatic polyvalent amine compounds and unsaturated carboxylic acids include methylenebis-acrylamide, methylenebis-methacrylamide, 1,6-hexamethylenebis-acrylamide, 1,6-hexamethylenebis-methacrylamide, diethylenetriamine trisacrylamide, xylylenebisacrylamide, and xylylenebismethacrylamide.

Other examples of the amide monomers preferably used in the present invention are amide monomers having a cyclohexylene structure as disclosed in JP KOKOKU No. Sho 54-21726.

In addition, urethane based addition-polymerizable compounds prepared by addition reaction of isocyanate with hydroxyl group are suitably used in the present invention. More specifically, there can be mentioned vinyl urethane compounds having two or more polymerizable vinyl groups in a molecule thereof, which is disclosed in JP KOKOKU No. Sho 48-41708, prepared by adding a hydroxyl-group containing vinyl monomer represented by the following formula (4) to a polyisocyanate compound having two or more isocyanate groups in a molecule thereof:

$$CH_2 = C(R^{41})COOCH_2CH(R^{42})OH \qquad (4)$$

wherein $R^{41}$ and $R^{42}$ each represent H or $CH_3$.

In addition to the above, also suitably used are urethane acrylate compounds which are disclosed in JP KOKAI No. Sho 51-37193 and JP KOKOKU No. Hei 2-32293 and JP KOKOKU No. Hei 2-16765; and urethane compounds having an ethylene oxide skeleton which are disclosed in JP KOKOKU Nos. Sho 58-49860, 56-17654, 62-39417, and 62-39418.

Another suitable class of radical-polymerizable compounds comprises radical-polymerizable compounds having an amino structure or sulfide structure in the molecule thereof as disclosed in JP KOKAI No. Sho 63-277653, JP KOKAI No. Sho 63-260909 and JP KOKAI No. Hei 1-105238.

Also, there can be mentioned polyfunctional acrylates and methacrylates such as polyester acrylates and epoxy acrylates obtained from a reaction of epoxy resin and (meth)acrylic acid as described in JP KOKAI No. Sho 48-64183, JP KOKOKU No. Sho 49-43191 and JP KOKOKU No. Sho 52-30490. Further, particular unsaturated compounds disclosed in JP KOKOKU Nos. Sho 46-43946, Hei 1-40337, and Hei 1-40336; and vinylphosphonic acid compounds disclosed in JP KOKAI No. Hei 2-25493 can also be used as the radical-polymerizable compounds. Moreover, a structure containing a perfluoroalkyl group disclosed in JP KOKAI No. Sho 61-22048 may also be preferably employed

in the present invention. The compounds referred to as photocurable monomers and oligomers in "Journal of the Adhesion Society of Japan" vol. 20, No. 7, pp 300 - 308 (1984) can also be used in the present invention.

It may be freely determined according to the final design for the performance of the image forming material which structure is selected for the radical-polymerizable compound, whether the above-mentioned radical-polymerizable compounds are used alone or in combination, what the amount of radical-polymerizable compounds is, and the like. For instance, the radical-polymerizable compounds may be determined in consideration of the following viewpoints. The more the number of unsaturated groups contained in one molecule in the structure, the more preferable in terms of sensitivity. In most cases, compounds having a functionality of two or more are preferable. Further, to improve the strength of the image area, that is, the cured film portion, compounds with a functionality of three or more are preferably used. Furthermore, the combination of the compounds with different functionalities and different polymerizable groups, which may be selected, for example, from acrylic ester compounds, methacrylic ester compounds, and styrene compounds, is effective for controlling both the photosensitivity and the strength of the image recording layer. Radical-polymerizable compounds having a high molecular weight and a strong hydrophobic nature tend to retard the developing speed and precipitate in the employed developing solution although excellent sensitivity and sufficient film strength can be obtained.

Selection of appropriate radical-polymerizable compound(s) and proper use of those compounds in the image recording layer become important factors in determining the compatibility of the radical-polymerizable compound(s) with other components contained in the image recording layer, e.g., a binder polymer, initiator, coloring agent and the like, and the dispersion properties of those components. For example, the use of a radical-polymerizable compound with low purity and the combination of two or more compounds can contribute to the increase in compatibility with other components. A particular structure may be adopted for the purpose of improving the adhesion of the image recording layer to the substrate or an overcoating layer to be provided on the image recording layer.

As the content of the radical-polymerizable compound in the image recording layer increases, the sensitivity can advantageously improve. However, an excessive amount of radical-polymerizable compound produces problems, for example, unfavorable phase separation. Further, there occurs another problem in the process of manufacture of the image forming material, to be more specific, transfer of the components contained in the image recording layer, and defective production because of increased adhesion of the image recording layer. In addition to the above, an excessive amount of radical-polymerizable compound causes precipitation in a developing solution to be employed.

In light of the above-mentioned points, the amount of the radical-polymerizable compound is suitably in the range of 5 to 80% by weight, preferably 20 to 75% by weight, based on the total weight of the composition of the image recording layer.

As mentioned above, those radical-polymerizable compounds may be used alone or in combination. The radical-polymerizable compounds may be freely determined in terms of structure, combination and amount to be added, with consideration given to the degree of inhibition against the polymerization due to oxygen, the resolution of the obtained image, the fogging properties, and a change in refractive index, and the surface tackiness of the obtained image recording layer. Furthermore, the image recording layer may be prepared by a multi-layered structure or a coating method for them, such as an undercoating or top coating, if required.

(C) Infrared absorbing agent

According to the image forming method of the present invention, image recording can be achieved by irradiation of infrared laser, so that the infrared absorbing agent is essential in the image recording layer. The infrared absorbing agent works to absorb the infrared light and convert it into heat energy. Due to heat thus generated, the radical generator is decomposed to generate radicals. The infrared absorbing agent for use in the present invention comprises dyes and pigments having a maximum absorption within a wavelength range from 760 to 1200 nm.

As the dyes suitably used as the infrared absorbing agent in the present invention, commercially available conventional dyes, and other dyes, for example, as mentioned in literatures such as "Handbook of Dyes", edited by The Society of Synthetic Organic Chemistry, Japan (1970) can be used. More specifically, preferably employed are dyes as listed in JP KOKAI No. Hei 10-39509 (in paragraphs [0050] and [0051]), e.g., azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes.

Preferable examples of the dyes serving as the infrared absorbing agents include cyanine dyes described, for example, in JP KOKAI Nos. Sho 58-125246, 59-84356, 59-202829, and 60-78787; methine dyes, in JP KOKAI Nos. Sho 58-173696, 58-181690, and 58-194595; naphthoquinone dyes, in JP KOKAI Nos. Sho 58-112793, 58-224793, 59-48187, 59-73996, 60-52940, and 60-63744; squarylium dyes, in JP KOKAI No. Sho 58-112792; and cyanine dyes, in G.B. Patent No. 434,875.

As the preferable examples of the infrared absorbing agent, there can also be mentioned near infrared absorbing sensitizers disclosed in U.S. Patent No. 5,156,938; substituted arylbenzo(thio)pyrylium salts disclosed in U.S.

Patent No. 3,881,924; trimethinethiapyrylium salts disclosed in JP KOKAI No. Sho 57-142645 (U.S. Patent No. 4,327,169); pyrylium compounds disclosed in JP KOKAI Nos. Sho 58-181051, 58-220143, 59-41363, 59-84248, 59-84249, 59-146063, and 59-146061; cyanine dyes disclosed in JP KOKAI No. Sho 59-216146; pentamethinethiapyrylium salts disclosed in U.S. Patent No. 4,283,475; and pyrylium compounds disclosed in JP KOKOKU Nos. Hei 5-13514 and 5-19702.

Furthermore, near-infrared absorbing dyes which are represented by formulas (I) and (II) in U.S. Patent No. 4,756,993 are also preferably used as the infrared absorbing agent.

Of the above-mentioned dyes, particularly preferable are cyanine dyes, squarylium dyes, pyrylium salts, and nickel thiolate complexes. Further, the cyanine dyes are especially suitable in the present invention, in particular, the following cyanine dyes represented by formula (5) are most preferable as the infrared absorbing agent.

(5) 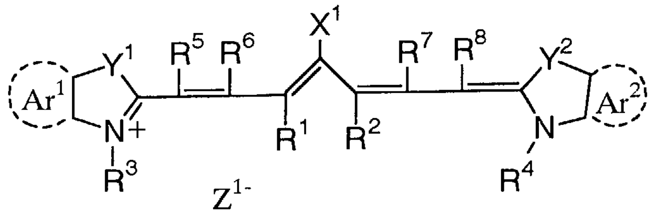

In the above formula (5), $X^1$ represents a halogen atom, or $X^2$ -$L^1$ or $NL^2$ $L^3$ , in which $X^2$ is oxygen atom or sulfur atom, $L^1$ is a hydrocarbon group having 1 to 12 carbon atoms, and $L^2$ and $L^3$ are each independently a hydrocarbon group having 1 to 12 carbon atoms. $R^1$ and $R^2$ are each independently a hydrocarbon group having 1 to 12 carbon atoms, preferably a hydrocarbon group having 2 or more carbon atoms in light of the storage stability of a coating liquid for the image recording layer. More preferably, $R^1$ and $R^2$ may form a 5- or 6-membered ring in combination.

$Ar^1$ and $Ar^2$ in formula (5) may be the same or different, and are each an aromatic hydrocarbon group which may have a substituent. $Y^1$ and $Y^2$, which may be the same or different, each represent sulfur atom or a dialkyl methylene group having 12 carbon atoms or less. $R^3$ and $R^4$, which may be the same or different, are each a hydrocarbon group having 20 carbon atoms or less which may have a substituent. In this case, preferable examples of the substituent for the hydrocarbon group include an alkoxyl group having 12 carbon atoms or less, carboxyl group, and sulfo group. $R^5$, $R^6$, $R^7$ and $R^8$, which may be the same or different, are each a hydrogen atom or a hydrocarbon group having 12 carbon atoms or less, preferably a hydrogen atom in light of availability of the raw material. $Z^{1-}$ represents a counter anion, but $Z^{1-}$ is not needed in the case where at least one of the groups represented by $R^1$ to $R^8$ has a sulfo group as a substituent. In consideration of the storage stability of a coating liquid for the image recording layer, it is preferable that $Z^{1-}$ represent a halogen ion, perchlorate ion, tetrafluoroborate ion, hexafluorophosphate ion, or sulfonate ion, more preferably perchlorate ion, trifluoromethylsulfonate ion, or arylsulfonate ion.

Specific examples of the cyanine dyes represented by formula (5) which are suitably used in the present invention are shown below.

[ IR-1 ] 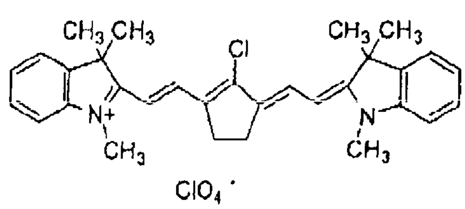

[ IR-2 ]

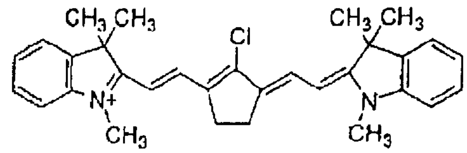

$PF_6^-$

[ IR-3 ]

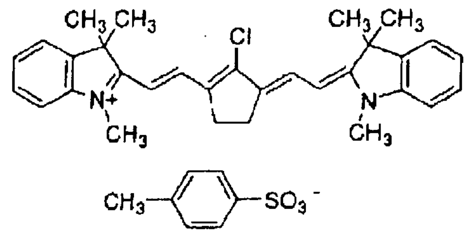

[ IR-4 ]

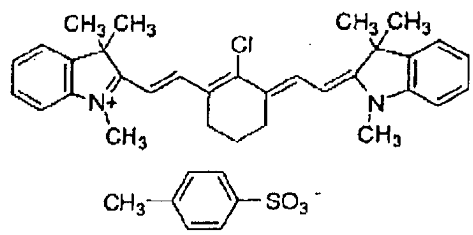

[ IR-5 ]

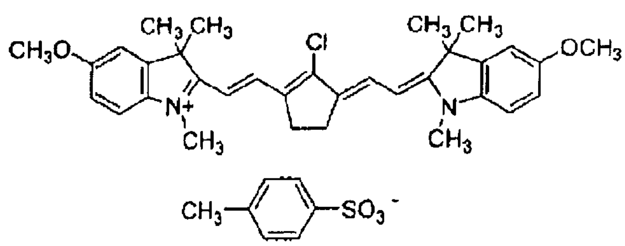

[IR-6]

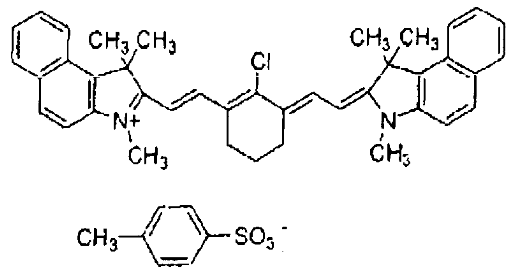

[IR-7]

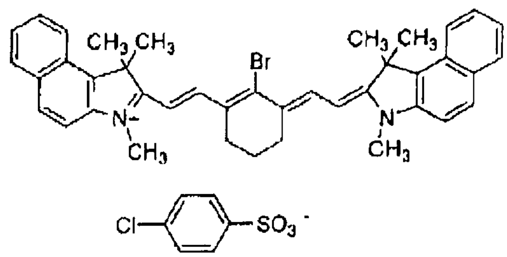

[IR-8]

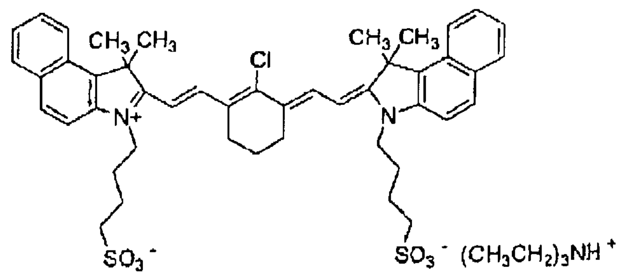

[IR-9]

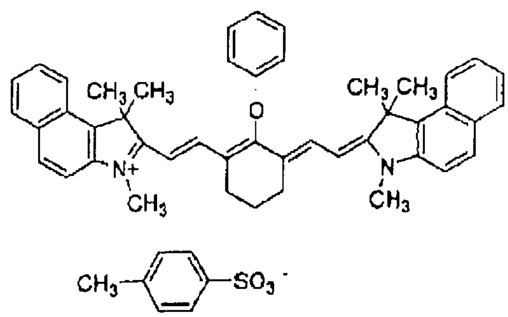

[ IR-10 ]

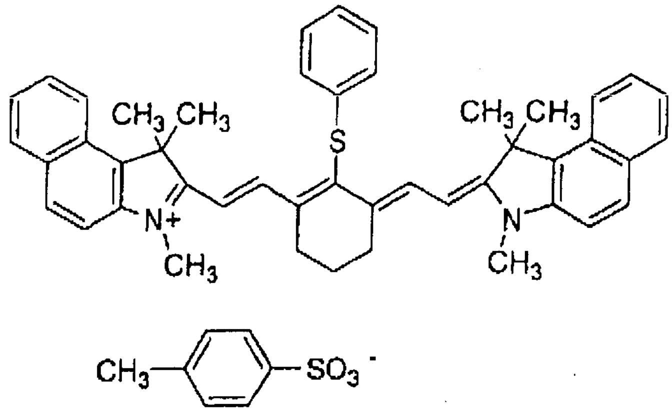

[ IR-11 ]

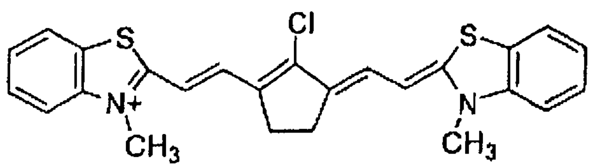

$ClO_4^-$

[ IR-12 ]

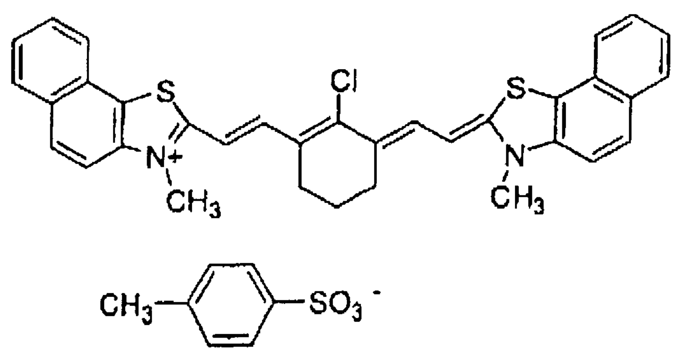

[IR-13]

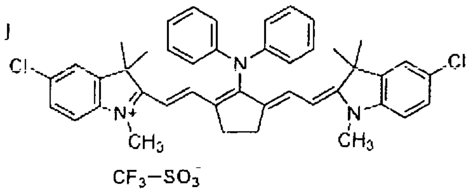

[IR-14]

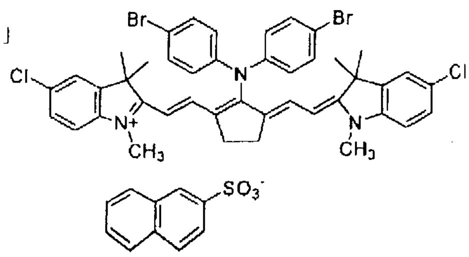

As the pigments used as the infrared absorbing agent, there can be employed commercially available pigments, and other pigments described in "Color Index (C.I.) Binran (Color Index Handbook)", "Saishin Ganryo Binran (The Latest Pigment Handbook)" edited by Nihon Ganryo Gijutsu Kyokai (1977), "Saishin Ganryo Oyo Gijutsu (The Latest Pigment Applied Technology)" CMC Publishing Co., Ltd. (1986), and "Insatsu Ink Gijutsu (Printing Ink Technology)" CMC Publishing Co., Ltd. (1984).

Various kinds of pigments can be used in the present invention, for example, black pigment, yellow pigment, orange pigment, brown pigment, red pigment, violet pigment, blue pigment, green pigment, fluorescent pigment, metallic flake pigment, and polymer-binding pigment. Those pigments are explained in detail in JP KOKAI No. Hei 10-39509 (in paragraphs [0052] - [0054]), which is incorporated herein by reference. In particular, carbon black is most preferably used in the present invention.

In the image recording layer, it is preferable that the amount of the above-mentioned dye or pigment be in the range of 0.01 to 50% by weight, more preferably 0.1 to 10% by weight, based on the total weight of a solid content of the image recording layer. In the case where the dye is used as the infrared absorbing agent, the amount of the dye is most preferably in the range of 0.5 to 10% by weight. In the case where the pigment is used, the amount of the pigment is most preferably in the range of 1.0 to 10% by weight.

When the amount of the infrared absorbing agent is less than 0.01% by weight, the sensitivity will be lowered. On the other hand, when the amount exceeds 50% by weight, the obtained image forming material will cause scumming when made into a lithographic printing plate.

(D) Binder polymer

The image recording layer comprises a binder polymer to improve the film properties of the obtained image recording layer. A linear organic polymer is preferably used as the binder polymer. Any linear organic polymers can be used, and in particular, linear organic polymers that are soluble or swellable in water or a weak alkaline aqueous solution may be selected because development with water or a weak alkaline aqueous solution can be carried out. The linear organic polymer may be selected in consideration of not only the performance as the film-forming agent for forming an image recording layer, but also the compatibility with a developing solution such as water, a weak alkaline aqueous solution, or an organic solution. For example, a water-soluble organic polymer allows development with water.

As the above-mentioned linear organic polymers, there can be mentioned radical polymers having carboxylic acid group in the side chain thereof as disclose in JP KOKAI No. Sho 59-44615, JP KOKOKU Nos. Sho 54-34327, 58-12577, and 54-25957, and JP KOKAI Nos. Sho 54-92723, 59-53836, and 59-71048, i.e., methacrylic acid copolymers, acrylic acid copolymers, itaconic acid copolymers, crotonic acid copolymers, maleic acid copolymers, partially esterified maleic acid copolymers, and the like. Acidic cellulose derivatives having a carboxylic acid group in the side chain thereof can also be used. Further, addition reaction products prepared by adding a cyclic acid anhydride to a hydroxyl-group containing polymer are also useful as the binder polymers.

In particular, (meth)acrylic resins having a benzyl group or aryl group and a carboxyl group in the side chain

thereof is suitably used in the present invention because such (meth)acrylic resins can offer an excellent balance of film strength, sensitivity and development performance.

Urethane binder polymers having an acid group as described in JP KOKOKU Nos. Hei 7-120040, 7-120041, 7-120042 and 8-12424, and JP KOKAI Nos. Sho 63-287944, Sho 63-287947, and Hei 1-271741 are advantageous in printing durability and suitability for low-power exposure because such urethane binder polymers exhibit significant strength.

Another examples of the water-soluble linear organic polymers useful as the binder polymers comprise polyvinyl pyrrolidone and polyethylene oxide. The use of alcohol-soluble nylon and polyether prepared from 2,2-bis-(4-hydroxyphenyl)-propane and epichlorohydrin is effective for increasing the strength of the cured film.

It is preferable that the binder polymer for use in the present invention have a weight-average molecular weight of 5,000 or more, and more preferably in the range of 10,000 to 300,000, and a number-average molecular weight of 1,000 or more, and more preferably in the range of 2,000 to 250,000. The polydispersity expressed as a ratio of the weight-average molecular weight to the number-average molecular weight is preferably 1 or more, and more preferably in the range of 1.1 to 10.

Such polymers may be in any form, for example, in the form of a random polymer, block polymer, or graft polymer. The binder polymer in the form of a random polymer is particularly preferable.

The binder polymers may be used alone or in combination. The binder polymer is suitably contained in the image recording layer in an amount of 20 to 95% by weight, preferably 30 to 90% by weight, based on the total weight of the solid content in a coating liquid for preparing the image recording layer. When the amount of the binder polymer is less than 20% by weight, an image area to be formed in the image recording layer will be lacking in strength. When the amount of the binder polymer exceeds 95% by weight, image formation will be impossible. It is preferable that the ratio of the amount of radical-polymerizable compound having ethylenically unsaturated double bond to the amount of linear organic polymer be in the range of 1/9 to 7/3 on a weight basis.

[Other components]

The image recording layer may further comprise a variety of compounds, if necessary, in addition to the above-mentioned components. For instance, a dye with a large absorption within the visible light range may be contained in the image recording layer as a coloring agent for the image area. Specific examples of such dyes are Oil Yellow #101, Oil Yellow #103, Oil Pink #312, Oil Green BG, Oil Blue BOS, Oil Blue #603, Oil Black BY, Oil Black BS, and Oil Black T-505 (all are products made by Orient Chemical Industries, Ltd.); Victoria Pure Blue, Crystal Violet (C.I.42555), Methyl Violet (C.I.42535), Ethyl Violet, Rhodamine B (C.I.145170B), Malachite Green (C.I.42000), and Methylene Blue (C.I. 52015); and dyes disclosed in JP KOKAI No. Sho 62-293247. In addition, pigments such as phthalocyanine pigments, azo pigments and titanium oxide are also preferably used as the coloring agent.

It is recommendable to add the above-mentioned coloring agent to the image recording layer because a clear distinction can be made between an image area and a non-image area after image formation. The amount of such a coloring agent is suitably in the range of 0.01 to 10% by weight based on the total weight of the solid content in a coating liquid for the image recording layer.

It is desirable to add a small amount of a heat-polymerization inhibitor to a coating liquid for the image recording layer in order to prevent the radical-polymerizable compound having ethylenically unsaturated double bond from causing undesired heat polymerization during the preparation of a coating liquid or the storage thereof. Specific examples of such a heat-polymerization inhibitor are hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), and N-nitroso-N-phenylhydroxylamine aluminum salts. The amount of the heat-polymerization inhibitor is preferably in the range of about 0.01 to about 5% by weight based on the total weight of the entire composition.

If necessary, the image recording layer coating liquid may further comprise higher fatty acids and derivatives thereof such as behenic acid and behenic acid amide, and alcohols such as 1-docosanol to decrease the coefficient of friction of the image recording layer and therefore to improve scratch resistance. The coating liquid for the image recording layer may be dried after application so that the higher fatty acid derivatives or alcohols may be localized in a surface portion of the image recording layer to be obtained. The amount of the higher fatty acid derivatives is preferably in the range of about 0.1 to about 10% by weight based on the total weight of the entire composition.

Furthermore, the coating liquid for the image recording layer may further comprise a nonionic surfactant as disclosed in JP KOKAI Nos. Sho 62-251740 and Hei 3-208514 and an ampholytic surfactant as disclosed in JP KOKAI Nos. Sho 59-121044 and Hei 4-13149 to ensure the processing stability under the wider developing conditions.

Examples of the nonionic surfactant are sorbitan tristearate, sorbitan monopalmitate, sorbitan trioleate, stearic acid monoglyceride, and polyoxyethylene nonylphenyl ether.

Examples of the ampholytic surfactant are alkyldi(aminoethyl)glycine, alkylpolyaminoethyl glycine hydrochloride, 2-alkyl-N-carboxyethyl-N-hydroxyethylimidazolinium betaine, and N-tetradecyl-N,N-betaine based surfactants

such as a commercially available surfactant "AMOGEN K" (trademark), made by Dai-ichi Kogyo Seiyaku Co., Ltd.

The total amount of the above-mentioned nonionic surfactant and ampholytic surfactant is preferably in the range of 0.05 to 15% by weight, more preferably in the range of 0.1 to 5% by weight in the coating liquid for the image recording layer.

A plasticizer may be contained in the coating liquid for the image recording layer, if necessary, to impart proper flexibility to the coated layer. Examples of the plasticizer include polyethylene glycol, tributyl citrate, diethyl phthalate, dibutyl phthalate, dihexyl phthalate, dioctyl phthalate, tricresyl phosphate, tributyl phosphate, trioctyl phosphate, and tetrahydrofurfuryl oleate.

To prepare an image forming material for use in the present invention, the above-mentioned components may be dissolved in an appropriate solvent to prepare a coating liquid for the image recording layer, and the coating liquid may be coated on a proper substrate. Examples of the solvent used for preparation of the coating liquid are ethylene dichloride, cyclohexane, methyl ethyl ketone, methyl isobutyl ketone, methanol, ethanol, propanol, ethylene glycol monomethyl ether, 1-methoxy-2-propanol, 1-methoxy-3-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, toluene, and water. Those solvents may be used alone or in combination. In the coating liquid for the image recording layer, the concentration of all the components, that is, the solid contents of the components including additive components in the solvent is preferably in the range of 1 to 50% by weight.

The deposition amount of the image recording layer obtained after the coating liquid is applied and dried varies depending upon the application of the image forming material to be obtained, but typically in the range of 0.5 to 5.0 g/$m^2$ when the image forming material is used for a lithographic printing plate. The coating liquid for the image recording layer may be applied to the substrate by various coating methods, for example, bar coater coating, spin coating, spray coating, curtain coating, dip coating, air knife coating, blade coating, roll coating and the like. As the deposition amount is decreased, the apparent sensitivity increases, but the film properties of the image recording layer provided with the function of image formation are impaired.

[Oxygen Barrier Protection Layer]

In the image forming material for use in the present invention, an oxygen barrier protection layer comprising a water-soluble vinyl polymer as the main component may be overlaid on the image recording layer thereof.

Examples of the water-soluble vinyl polymers for use in the oxygen barrier protection layer include a polyvinyl alcohol which may be partially substituted with ester, ether and acetal; and a copolymer comprising such a partially substituted vinyl alcohol unit and an unsubstituted vinyl alcohol unit in such a substantial amount that can impart the required water-solubility to the resultant copolymer. In the protection layer, polyvinyl alcohols hydrolyzed to the extent of 71 to 100% and have a degree of polymerization of 300 to 2400 are preferably used. Specific examples of the commercially available polyvinyl alcohol products are PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-220, PVA-224, PVA-217EE, PVA-217E, PVA-220E, PVA-224E, PVA-405, PVA-420, PVA-613, and L-8, which are made by KURARAY Co., Ltd. Examples of the above-mentioned copolymers preferably used in the oxygen barrier protection layer include polyvinyl acetate chloroacetate or propionate, polyvinyl formal, polyvinyl acetal and copolymer thereof, which are preferably hydrolyzed to the extent of 88 to 100%. In addition to the above, polyvinyl pyrrolidone, gelatin, and gum arabic are also effectively used for the oxygen barrier protection layer. These polymers may be used alone or in combination.

When the oxygen barrier protection layer is provided by coating, purified water is preferably used alone as a solvent, or in combination with alcohols such as methanol and ethanol, and ketones such as acetone and methyl ethyl ketone. It is proper that the solid content in the coating liquid for formation of the oxygen barrier protection layer be in the range of 1 to 20% by weight.

The oxygen barrier protection layer may further comprise well known additives such as a surfactant for improving the coating characteristics and a water-soluble plasticizer for enhancing the physical properties of the obtained layer.

Examples of the above-mentioned water-soluble plasticizer include propionamide, cyclohexanediol, glycerin, and sorbitol. Water-soluble (meth)acrylic polymers may be added.

The coating amount for the oxygen barrier protection layer is suitably in the range of about 0.1 to about 15 g/$m^2$, preferably in the range of about 1.0 to about 5.0 g/$m^2$ on a dry basis.

[Substrate]

In the image forming material for use in the present invention, any dimensionally stable plate-shaped materials

can be used as the substrate for supporting the previously mentioned image recording layer thereon. Preferably used are a sheet of paper; a laminated sheet prepared by covering paper with a thin layer of plastic, such as polyethylene, polypropylene, or polystyrene; a metal plate made of, for example, aluminum, zinc or copper; a plastic film made of, for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, or polyvinyl acetal; and a sheet of paper or plastic film to which the above-mentioned metals are attached or vapor deposited. A polyester film and an aluminum plate are particularly preferable as the substrate in the present invention.

In particular, it is preferable to use as the substrate for the image forming material an aluminum plate that is light and can be easily surface-treated, and is excellent in workability and corrosion resistance. In light of those requirements, aluminum materials in accordance with JIS 1050, JIS 1100, and JIS 1070, and aluminum alloy materials such as Al-Mg alloy, Al-Mn alloy, Al-Mn-Mg alloy, Al-Zr alloy, and Al-Mg-Si alloy are useful.

When the image forming material is obtained by providing the previously mentioned image recording layer on the aluminum plate which has been surface-treated to have a proper surface roughness, the image forming material can be subjected to making a lithographic printing plate. For the surface roughening treatment, mechanical roughening, chemical roughening and electrochemical roughening methods may be adopted alone or in combination. Prior to the surface roughening treatment, the aluminum plate may be subjected to anodization for improving wear resistance of the surface, or some treatment for enhancing the hydrophilic properties of the surface portion of the aluminum plate.

The surface treatment for finishing the aluminum substrate for use in the present invention will now be explained in detail.

The aluminum plate may be first subjected to degreasing, if required, before the surface roughening treatment, using a surfactant, organic solvent, or an aqueous alkaline solution to remove rolling oil from the surface of the aluminum plate. In the case where an alkaline solution is used for the degreasing, neutralization with an acidic solution, followed by desmutting may be carried out.

Next, the surface of the aluminum plate is roughened, that is, subjected to graining in order to improve the adhesion to the image recording layer and impart water retention properties to the non-image area to be formed. To provide the aluminum plate with a grained surface, mechanical surface-graining such as sandblasting, and chemical graining using an etching agent such as an alkali or acid, or mixtures thereof can be used. In addition, electrochemical graining is also effective, and other conventional graining methods can be also employed, for example, a method of attaching grains to an aluminum plate by means of an adhesive or the like, and a method of pressing an aluminum plate against a continuous belt or roller having a fine surface roughness to transfer such a fine grained pattern to the aluminum plate.

The above-mentioned methods for roughening the surface may be employed in combination. In this case, the order and the repetition number of the methods may be determined freely. Since smut is present on the grained surface of the aluminum plate, the aluminum plate may be appropriately washed with water or subjected to alkali etching for desmutting.

After the above-mentioned pre-treatment for the aluminum plate, an anodized film is generally provided on the aluminum plate by anodization to improve the wear resistance, chemical resistance and water retention properties.

Any material can be used as an electrolyte in the anodization of the aluminum plate so long as a porous anodized film can be formed on the surface of the aluminum plate. Typically, sulfuric acid, phosphoric acid, oxalic acid, hydrochloric acid, nitric acid, and mixtures thereof are used as the electrolyte. The concentration of the electrolyte is appropriately determined depending upon the kind of electrolyte. The operating conditions for the anodization cannot be particularly specified because they depend on the type of electrolyte. In general, it is proper that the concentration of the electrolyte be in the range of 1 to 80%, the liquid temperature be controlled to 5 to 70°C, the current density be in the range of 5 to 60 A/dm$^2$, the applied voltage be in the range of 1 to 100 V, and the time for electrolysis be in the range of 10 seconds to 5 minutes. The deposition amount of the anodized film is preferably 1.0 g/m$^2$ or more, and more preferably in the range of 2.0 to 6.0 g/m$^2$. When the deposition amount of the anodized film is less than 1.0 g/m$^2$, the printing durability will be insufficient, and the non-image area in the lithographic printing plate will be susceptible to scratches, and the scratches, if made on the printing plate, will be contaminated by ink during the printing operation, i.e., toning by the scratches on the non-image area will be possibly caused.

After completion of the anodization, the surface of the aluminum plate is subjected to a treatment such as silicate treatment to make the surface hydrophilic, if required.

The aluminum plate may be surface-treated with organic acids or salts thereof after anodization. Alternatively, an undercoating for providing the image recording layer may be applied to the aluminum plate.

The image forming material may further comprise an intermediate layer between the substrate and the image recording layer in order to improve the adhesion therebetween. For the purpose of enhancing the adhesion, the intermediate layer may comprise a diazo resin, a phosphonic acid compound, a phosphoric acid compound, or an aluminum compound such as aluminum alkoxide. The thickness of the intermediate layer is not particularly specified, but may be adjusted so that the intermediate layer can perform a homogenous bond forming reaction with the image recording

layer, at the time of exposure. Typically, the deposition amount of the intermediate layer is preferably in the range of about 1 to 100 mg/m$^2$, more preferably in the range of 5 to 40 mg/m$^2$ on a dry basis.

After the substrate is surface-treated in the above-mentioned manner or the undercoating is applied thereto, a backcoating layer may be provided on the rear side of the substrate if necessary. It is preferable that the backcoating layer comprises organic polymer compounds as described in JP KOKAI No. Hei 5-45885, or metal oxides obtained from hydrolysis and polycondensation of inorganic or organic metal compounds as described in JP KOKAI No. Hei 6-35174.

In light of the application to a lithographic printing plate, the substrate has preferably a surface roughness in the range of 0.10 to 1.2 µm in terms of center-line mean roughness. When the surface roughness is less than 0.10 µm, the adhesion of the substrate to the image recording layer is decreased, which will considerably lower the printing durability. The substrate with a surface roughness of more than 1.2 µm will tend to cause scumming during the printing operation. The color density of the substrate is preferably in the range of 0.15 to 0.65 in terms of reflection density. When the reflection density is less than 0.15, image formation will be hindered by halation at the time of image exposure. In contrast to this, when the substrate has a reflection density of more than 0.65, images formed in the image recording material through development will become illegible, and therefore the operation of checking the printing plate cannot be conducted efficiently.

The negative type image forming material for use in the present invention can be prepared by the above-mentioned method. Images can be recorded in the image recording material using infrared laser beams. In addition, the image forming material can also cope with thermal image formation using an ultraviolet lamp and a thermal head. In the present invention it is preferable that the image forming material be exposed to light images using solid lasers or semiconductor lasers capable of infrared radiation having wavelengths ranging from 760 to 1200 nm. The output power of the employed laser is preferably 100 mW or more, and the use of a multi-beam laser device is particularly preferable to curtail the exposure time. The exposure time is preferably 20 µsec or less per picture element, and the energy applied to the image forming material is preferably in the range of 10 to 300 mJ/cm$^2$.

After completion of the image exposure using the lasers, the image recording material is developed with the alkaline developing solution as previously described.

Then, the image forming material is subjected to post-treatment using a washing water, a rinsing solution containing a surfactant, or a desensitizing solution containing gum arabic, starch derivatives or the like. The image forming material is thus made into a lithographic printing plate.

In recent years, the automatic processor for making a printing plate has been widely adopted to promote streamlining and standardization of the plate making operation in the plate-making and printing industries. The automatic processor generally includes a development area and a post-treatment area, provided with a unit for transporting a plate for preparing the printing plate, various liquid tanks, and a unit for spraying each liquid onto the plate. With the plate subjected to light exposure being horizontally transported in the automatic processor, development is carried out in such a manner that each liquid necessary for development is scooped up by a pump and sprayed through a spray nozzle onto the plate. There is also known another method that the plate is dipped in each processing liquid by causing the plate to pass through the liquid tank by the aid of a guide roll. In such an automatic operation, the respective replenishers are added to the liquid tanks according to the consumed amounts of the liquids and the operating time. Further, replenishment of those liquids can be automatically controlled by detecting the electroconductivity and pH value using sensors. Furthermore, the so-called disposable system is applicable to the above-mentioned automatic processor. To be more specific, the plate can be treated with substantially unused liquids, i.e., fresh liquids, and such liquids are thrown away after onetime use.

The lithographic printing plate thus obtained is ready for printing operation after application of a desensitizer if desired. To provide the printing plate with a still higher printing durability, the printing plate may be subjected to a post-exposure treatment and a burning treatment. When the lithographic printing plate is subjected to burning, it is preferable that the plate be treated with a plate cleaner before burning as described in JP KOKOKU Nos. Sho 61-2518 and 55-28062, JP KOKAI Nos. Sho 62-31859 and 61-159655. More specifically, the treatment with a plate cleaner may be carried out by wiping the plate with a sponge or absorbent cotton impregnated with the plate cleaner, immersing the printing plate in a vat filled with the plate cleaner, or by coating the plate cleaner on the plate using an automatic coater. Further, when the deposition amount of the plate cleaner is made even using a squeegee or squeegee roll after application of the plate cleaner, more favorable results can be obtained. It is proper that the deposition amount of the plate cleaner be usually in the range of 0.03 to 0.8 g/m$^2$ on a dry basis.

The lithographic printing plate coated with a plate cleaner is dried when necessary, and then subjected to the burning treatment by heating the plate to high temperatures using a burning processor, for example, a commercially available burning processor "Model BP-1300" (trademark) available from Fuji Photo Film Co., Ltd. The heating temperature and heating time, which vary depending upon the kinds of components constituting the image area formed in the printing plate, are preferably controlled to 100 to 300°C and 1 to 20 minutes, respectively.

After completion of the burning treatment, the printing plate may appropriately be subjected to conventional

treatments, such as washing with water, and coating of a desensitizing gum. When the printing plate has been treated with a plate cleaner containing a water-soluble polymer compound, the desensitizing treatment such as coating of the desensitizing gum is not necessary at this stage.

The lithographic printing plate thus prepared by the image forming method of the present invention is set in an offset press or the like to produce a large number of printed materials.

Other features of this invention will become apparent in the course of the following description of exemplary embodiments, which are given for illustration of the invention and are not intended to be limiting thereof.

Example 1

[Preparation of Substrate]

An aluminum web (JIS 1050) with a thickness of 0.30 mm was washed with trichloroethylene for degreasing, and subjected to surface-graining using the combination of a nylon brush and an aqueous suspension of 400-mesh pumice stone, and thereafter completely washed with water.

Then, the aluminum web was immersed in a 25% aqueous solution of sodium hydroxide maintained at 45°C for 9 seconds for etching. After that, the aluminum web was washed with water, and then immersed in a 2% aqueous solution of $HNO_3$ for 20 seconds, followed by washing with water. The etched amount, that is, the amount of aluminum removed from the aluminum web by graining was about 3 g/m$^2$.

After completion of the graining by etching, the aluminum web was subjected to anodization using 7% sulfuric acid as an electrolyte at a current density of 15 A/dm$^2$, so that an anodized film was deposited on the surface of the aluminum web with a deposition amount of 3 g/m$^2$. Thereafter, the aluminum web was subjected to a silicate treatment to ensure the hydrophilic properties of a non-image area to be formed in the printing plate. To be more specific, the aluminum web was caused to pass through a 1.5% aqueous solution of No. 3 sodium silicate maintained at 70°C over a period of 15 seconds. After that, the aluminum web was washed with water. The deposition amount of Si was 10 mg/m$^2$.

[Formation of Undercoating Layer]

An undercoating with the following formulation was coated on the above-mentioned aluminum plate using a wire bar, and dried at 90°C for 30 seconds with a hot-air dryer, so that an undercoating layer was provided on the aluminum substrate. The deposition amount of the undercoating layer was 80 mg/m$^2$ on a dry basis.

(Formulation for undercoating)

Aluminum alkyl acetoacetate diisopropylate "Aluminum Chelate M" (trademark) made by

| | |
|---|---|
| Kawaken Fine Chemicals Co., Ltd. | 1.0 g |
| Methanol | 100 g |
| Deionized water | 10 g |

[Formation of Image Recording Layer]

A coating liquid for image recording layer with the following formulation was coated on the above-mentioned undercoating layer using a wire bar, and dried at 120°C for 45 seconds with a hot-air dryer, so that an image recording layer was provided. An image forming material [P-1] for a lithographic printing plate was obtained according to the present invention. The deposition amount of the image recording layer was 2.0 g/m$^2$ on a dry basis.

| (Formulation for image recording layer coating liquid) | |
|---|---|
| Onium salt [OS-7] | 0.25 g |
| Polymerizable compound [RM-1] | 0.60 g |
| Infrared absorbing agent [IR-13] | 0.06 g |
| Polymer [PB-1] | 1.40 g |
| Naphthalenesulfonate salt of Victoria Pure Blue | 0.04 g |
| 1-docosanol | 0.01 g |
| Polymerization inhibitor ("IRGANOX 1010" (trademark), made by CIBA Specialty Chemicals Inc.) | 0.005 g |

(continued)

| (Formulation for image recording layer coating liquid) | |
|---|---|
| Fluorine-containing surfactant ("MEGAFAC KF309" (trademark), made by Dainippon Ink & Chemicals, Incorporated) | 0.03 g |
| Methyl ethyl ketone | 10 g |
| γ - butyrolactone | 5 g |
| Methanol | 7 g |
| 1-methoxy-3-propanol | 5 g |

The polymer (PB-1) for use in the above-mentioned formulation for the image recording layer coating liquid was prepared by first synthesizing a copolymer from (a) methacrylic acid, (b) acrylamide, and (c) benzyl methacrylate and thereafter reacting the obtained copolymer with (d) 3-chloro-2-hydroxypropyl methacrylate in the presence of a base and potassium iodide. The molar ratio of (a):(b):(c):(d) was 15:30:15:40, and the weight-average molecular weight of the obtained polymer (PB-1) was 100,000.

The compounds for use in the above formulation have the respective chemical structures shown below.

[OS-7]

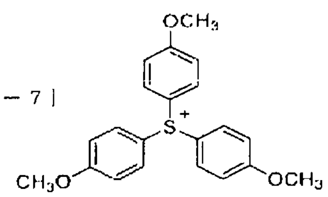

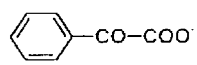

[RM-1]

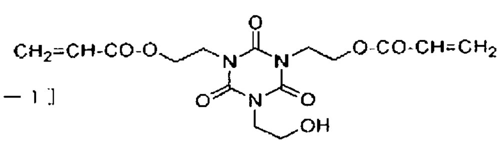

[IR-13]

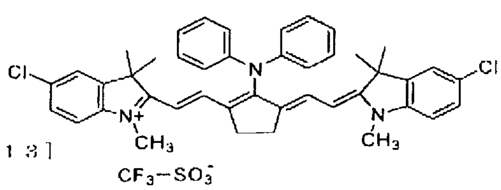

[PB-1]

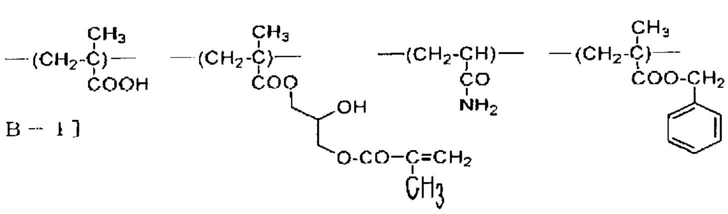

[Preparation of Developing Solutions]

Each developing solution was prepared as shown below.

(Developing solution No. 1 (pH = 10.5))

A developing solution No. 1 was prepared by dissolving phosphoric acid (pka: 12.4) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Developing solution No. 2 (pH = 10.5))

A developing solution No. 2 was prepared by dissolving sulfosalicylic acid (pka: 11.7) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Developing solution No. 3 (pH = 10.5))

A developing solution No. 3 was prepared by dissolving p-cresol (pka: 10.27) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Developing solution No. 4 (pH = 10.5))

A developing solution No. 4 was prepared by dissolving o-cresol (pka: 10.33) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Developing solution No. 5 (pH = 10.5))

A developing solution No. 5 was prepared by dissolving m-cresol (pka: 10.09) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Developing solution No. 6 (pH = 10.5))

A developing solution No. 6 was prepared by dissolving L-ascorbic acid (pka: 11.34) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.0.

Y-1

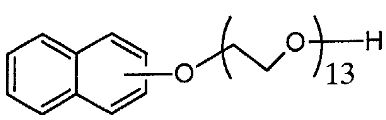

[Evaluations of Developing Solution Compositions]

Evaluations of the developing solutions were carried out using a CTP output system available from Fuji Photo Film Co., Ltd., comprising a plate supplier (trademark: SA-L 8000), an exposure device (trademark: LUXEL T-9000 CTP), a plate conveyor (trademark: T-9000 CONVEYOR), an automatic processor (trademark: LP-1310H) and a stacker (trademark: ST-1160). A developer tank of the automatic processor was filled with each of the developing solutions

No. 1 to No. 6, which was maintained at 30°C. Further, in the automatic processor, there were disposed a second tank provided with tap water and a third tank provided with a finishing gum solution prepared by diluting a finishing gum (trademark: FN-6 made by Fuji Photo Film Co., Ltd.) with water at a ratio of 1:1.

With the image forming material for lithographic printing plate [P-1] being set in the plate supplier of the CTP output system, continuous operation of light exposure and development using each of the developing solutions No. 1 to No. 6 was automatically conducted, and finally the plate was discharged into the stacker. The resolution was adjusted to 2400 dpi with 175 lines/inch at the time of exposure with the dot percent being changed within a range from 0.5 to 99.5%. It was visually observed with a magnifier whether dot formation on each printing plate was acceptable or not. The result was that the dot formation was satisfactory at any dot percent from 0.5 to 99.5% in all cases.

Each of the lithographic printing plates thus obtained and a commercially available black offset ink "GEOS-G", (trademark), made by Dainippon Ink & Chemicals, Incorporated were set in a printing press "Model R201" (trademark), made by MAN Roland Druckmaschinen AG, to carry out a printing operation. In the case where the printing plates obtained through the development with the developing solutions Nos. 2, 4 and 6 were subjected to the printing operation, there occurred printing failure when 100,000 prints were made. When the printing plates obtained through the development with the developing solutions Nos. 1, 3 and 5 were used, printing failure was caused when 90,000 prints were made.

Example 2

(Evaluations of Processing Stability in Developing Solutions with Time)

Similarly in Example 1, a developer tank of the automatic processor was filled with each of the developing solutions No. 1 to No. 6. Then, the image forming material [P-1] for lithographic printing plate prepared in Example 1 was set in the CTP output system, and 10 $m^2$ of the image forming material [P-1] was subjected to development without replenisher. A pH value in the developing solutions was measured at the time of initiation of process and at the time of 10 $m^2$ throughput of the material. In the result, the changes of pH value of the developing solutions were found to be from 10.5 to 10.1 for the developing solution No.1, from 10.5 to 10.2 for the developing solutions Nos. 2, 3, 5, and 6, and from 10.5 to 10.3 for the developing solution No. 4. In addition, change of image formation was evaluated in the same manner of Example 1, and specifically it was visually observed with a magnifier whether dot formation on each printing plate obtained was acceptable or not. The result was that the dot formation was satisfactory at any dot percent from 0.5 to 99.0~99.5% in all developing solutions No. 1 to No. 6 at the time of 1$m^2$, 5$m^2$ and 10$m^2$ throughput of material.

Comparative Example 1

The procedure for image formation on the image forming material [P-1] in Example 1 was repeated except that comparative developing solutions Nos. 1, 2, 3 and 4 shown below, respectively were used for development. Thus, a comparative lithographic printing plate of negative-type was obtained.

(Comparative developing solution No. 1 (pH = 10.5))

A comparative developing solution No. 1 was prepared by dissolving 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Comparative developing solution No. 2 (pH = 10.5))

A comparative developing solution No. 2 was prepared by dissolving 5% by weight of sodium dibutyl naphthalenesulfonate (anionic surfactant) and 0.2% by weight of ethylenediaminetetraacetic acid · 4Na salt (chelating agent) in water and adding potassium hydroxide to the aqueous solution to have a pH value of 10.5.

(Comparative developing solution No. 3 (pH = 10.5))

A comparative developing solution No. 3 was prepared by dissolving salicylic acid (pka: 13.61) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Comparative developing solution No. 4 (pH = 10.5))

A comparative developing solution No. 4 was prepared by dissolving 2-amino methyl pyrimidine (pka: 8.51) in an amount of 0.15 mole/liter, 5% by weight of a surfactant represented by formula Y-1 and 0.2% by weight of ethylenediaminetetraacetic acid·4Na salt (chelating agent) in water and adding potassium hydroxide to the aqueous solution to have a pH value of 10.5.

(Evaluations)

The images formed in the comparative lithographic printing plate were visually observed with a magnifier in terms of dot formation. The result was that the dot formation was satisfactory at a dot percent ranging from 0.5 to 99.5% in the comparative developing solution Nos. 1, 3 and 4, and the dot formation was satisfactory at a dot percent ranging from 2 to 98% in the comparative developing solution No. 2, although minute dots were not formed at a dot percent of 0.5%, 1%, 99% and 99.5%.

Then, the comparative lithographic printing plate was set in the same printing press to carry out a printing operation in the same manner as in Example 1. In this case, there occurred printing failure when 90,000 prints were made for the comparative developing solutions Nos. 1, 3 and 4, and there occurred printing failure when 70,000 prints were made for the comparative developing solution No. 2.

The comparative developing solutions No. 1 to No. 4 were evaluated in terms of processing stability with time in the same manner as in Example 2. After a developer tank of the automatic processor was filled with each of the comparative developing solutions No. 1 to No. 4, the image forming material [P-1] for lithographic printing plate was set in the CTP output system, and 10 $m^2$ of the image forming material [P-1] was subjected to development without replenisher. A change of a pH value of the developing solution was determined during $10m^2$ throughput of the material, and a pH value of 10.5 at the initial stage changed to a pH value of 9.8 at the time of $2m^2$ throughput of the material in all the comparative developing solutions No. 1 to No. 4, and then there was observed that non-image areas were not developed.

[Comparative Example 2]

The procedure for image formation on the image forming material [P-1] in Example 1 was repeated except that a comparative developing solution No. 5 shown below was used for development. Thus, a comparative lithographic printing plate of negative-type was obtained.

(Comparative developing solution No. 5 (pH = 12.5))

A comparative developing solution No. 5 was prepared by dissolving 5% by weight of sodium dibutyl naphthalenesulfonate (anionic surfactant) and 0.2% by weight of ethylenediaminetetraacetic acid · 4Na salt (chelating agent) in water and adding potassium hydroxide to the aqueous solution to have a pH value of 12.5.

(Evaluations)

The images formed in the comparative lithographic printing plate were visually observed with a magnifier in terms of dot formation. The result was that the dot formation was satisfactory at a dot percent ranging from 5 to 99.5%, although minute dots were not formed at a dot percent of 0.5%, 1%, 2%, 3% and 4%.

Then, the comparative lithographic printing plate was set in the same printing press to carry out a printing operation in the same manner as in Example 1. In this case, there occurred printing failure when 40,000 prints were made.

The results obtained in the Examples and the Comparative Examples are summarized below.

Table 1

| Developing Solution | Example 1 | | Example 2 | |
|---|---|---|---|---|
| | Dot Formation | Printing Durability (prints) | pH change from start to $10m^2$ throughput (variation) | Dot Formation at $10m^2$ throughput |
| No.1 | 0.5 - 99.5% | 90,000 | 10.5→10.1 (▲0.4) | 0.5 - 99.0% |
| No.2 | 0.5 - 99.5% | 100,000 | 10.5→10.2 (▲0.3) | 0.5 - 99.5% |

Table 1 (continued)

| Developing Solution | Example 1 | | Example 2 | |
|---|---|---|---|---|
| | Dot Formation | Printing Durability (prints) | pH change from start to $10m^2$ throughput (variation) | Dot Formation at $10m^2$ throughput |
| No.3 | 0.5 - 99.5% | 90,000 | 10.5→10.2 (▲0.3) | 0.5 - 99.5% |
| No.4 | 0.5 - 99.5% | 100,000 | 10.5→10.3 (▲0.2) | 0.5 - 99.5% |
| No.5 | 0.5 - 99.5% | 90,000 | 10.5→10.2 (▲0.3) | 0.5 - 99.0% |
| No.6 | 0.5 - 99.5% | 100,000 | 10.5→10.2 (▲0.3) | 0.5 - 99.5% |

Table 2

| Comparative Developing Solution | Comparative Example 1 | | | |
|---|---|---|---|---|
| | Dot Formation | Printing durability (prints) | pH change from start to $2m^2$ throughput (variation) | Dot Formation at $2m^2$ throughput |
| No.1 | 0.5-99.5% | 90,000 | 10.5→9.8 (▲0.7) | NG* |
| No.2 | 2-98% | 70,000 | 10.5→9.8 (▲0.7) | NG* |
| No.3 | 0.5-99.5% | 90,000 | 10.5→9.8 (▲0.7) | NG* |
| No.4 | 0.5-99.5% | 90,000 | 10.5→9.8 (▲0.7) | NG* |

* Residue was observed.

Table 3

| Comparative Developing Solution | Comparative Example 2 | |
|---|---|---|
| | Dot Formation | Printing Durability (prints) |
| No.5 | 5 - 99.5% | 40,000 |

As previously mentioned, the present invention can provide an excellent image forming method using a negative-type image forming material, capable of forming images therein by direct transfer of digital data from computers or the like using infrared lasers. More specifically, the above-mentioned image forming method exhibits excellent image forming properties and can provide a lithographic printing plate with high printing durability, even though the image forming material is not subjected to heat treatment after light exposure. Further, the image forming method of the present invention can make lithographic printing plates with constant and stable quality continuously, since a pH value of the alkaline developing solution used is stable in the course of development processing procedure.

## Claims

1. An image forming method comprising the steps of exposing a negative type image forming material to infrared laser imagewise, which image forming material comprises a substrate and an image recording layer formed thereon, comprising (A) a radical generator, (B) a radical-polymerizable compound, (C) an infrared absorbing agent, and (D) a binder polymer; and developing the image forming material with an alkaline developing solution comprising a weak acid or a salt thereof having a dissociation constant pka of from 10 to 13.

2. The method of claim 1 wherein the weak acid or the salt thereof having a dissociation constant pka of from 10 to 13 is selected from the group consisting of alcohols, aldehydes, a compound having a phenolic hydroxyl group, sugars, oximes, a nucleic acid related compound, a weak acid and a salt thereof.

**3.** The method of claim 1 wherein the weak acid or the salt thereof having a dissociation constant pka of from 10 to 13 is at least one selected from 2,2,3,3-tetrafluoropropanol-1 (pka: 12.74), trifluoroethanol (pka: 12.37), trichloroethanol (pka: 12.24), pyridine-2-aldehyde (pka:12.68), pyridine-4-aldehyde (pka: 12.05), salicylic acid (pka: 13.0), 3-hydroxy-2-naphthoic acid (pka: 12.8), catechol (pka: 12.6), gallic acid (pka:12.4), sulfosalicylic acid (pka: 11.7), 3,4-dihydroxysulfonic acid (pka: 12.2), 3,4-dihydroxybenzoic acid (pka: 11.94), 1,2,4-trihydroxybenzen (pka: 11.82), hydroquinone (pka:11.56), pyrogallol (pka: 11.34), o-cresol (pka: 10.33), resorcinol (pka: 11.27), p-cresol (pka: 10.27), m-cresol (pka: 10.09), sorbitol (pka: 13.0), sucrose (pka: 12.7), glucose (pka: 12.46), L-ascorbic acid (pka:11.34), 2-butanoneoxime (pka: 12.45), acetoxime (pka: 12.42), 1,2-cycloheputadione dioxime (pka: 12.3), 2-hydroxybenzaldehyde oxime (pka: 12.10), dimethylglyoxime (pka: 11.9), ethanediamide dioxime (pka: 11.37), acetophenone oxime (pka: 11.35), adenosine (pka: 12.56), inosine (pka: 12.5), guanine (pka: 12.3), cytosine (pka: 12.2), hypoxanthine (pka: 12.1), xanthine (pka: 11.9), diethylaminomethylphosphonic acid (pka: 12.32), 1-amino-3,3,3-trifluorobenzoic acid (pka: 12.29), isopropylidene diphosphonic acid (pka: 12.10), 1,1-ethylidene diphosphonic acid (pka: 11.54), 1,1-ethylidene diphosphonic acid 1-hydroxy (pka: 11.52), benzimidazole (pka: 12.86), thiobenzamide (pka: 12.8), picoline thioamide (pka: 12.55), barbituric acid (pka: 12.5), phosphoric acid (pka: 12.4), metasilicic acid (pka: 12.0), orthosilicic acid (pka: 12.0), arsenic acid (pka: 11.5), hydrogen peroxide (pka: 11.6), hydrogen sulfide (pka: 11.9), carbonic acid (pka: 10.33) and an alkaline metal salt thereof.

**4.** The method of claim 1 wherein the weak acid or the salt thereof having a dissociation constant pka of from 10 to 13 is at least one selected from sulfosalicylic acid, phosphoric acid, inosine, acetoxime, sucrose, p-cresol, o-cresol, m-cresol, L-ascorbic acid, carbonic acid and a salt thereof.

**5.** The method of claim 1 wherein the alkaline developing solution comprises the weak acid or the salt thereof having a dissociation constant pka of from 10 to 13 in an amount of from 0.01 to 1 mole/liter.

**6.** The method of claim 1 wherein the alkaline developing solution further comprises a nonionic surfactant and/or an anionic surfactant.

**7.** The method of claim 6 wherein the nonionic surfactant is at least one nonionic surfactant having an aromatic ring represented by the following formula:

$$X\text{-}Y\text{-}O\text{-}(A)n\text{-}(B)m\text{-}H$$

wherein X is an aromatic ring; Y represents a single bond or an alkylene group having 1 to 10 carbon atoms; A and B, which are different from each other, represent $-CH_2CH_2O-$ or $-CH_2CH(CH_3)O-$; and n and m each represent 0 or an integer of from 1 to 100, provided that n and m are not 0 at the same time.

**8.** The method of claim 7 wherein the nonionic surfactant is at least one selected from the group consisting of compounds represented by the following formula (I-A) or (I-B):

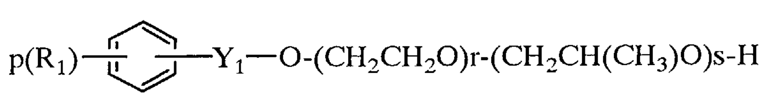

(I-A)

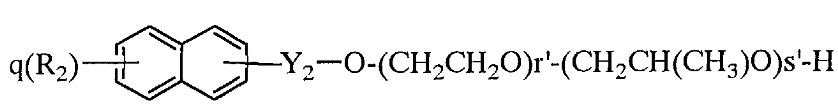

(I-B)

wherein $R_1$ and $R_2$ each represents hydrogen atom or an organic residue having 1 to 100 carbon atoms; p and q each represents an integer of 1 or 2, $Y_1$ and $Y_2$ each represents a single bond or an alkylene group having 1 to 10 carbon atoms; r and s each represents 0 or an integer ranging from 1 to 100 provided that r and s are not 0 at the same time; r' and s' each represents 0 or an integer ranging from 1 to 100 provided that r' and s' are not 0 at the same time.

**9.** The method of claim 8 wherein $R_1$ and $R_2$ each represents hydrogen atom or an organic residue selected from

aliphatic hydrocarbon groups, aromatic hydrocarbon groups, alkoxy, aryloxy, N-alkylamino, N,N-dialkylamino, N-arylamino, N,N-diarylamino, N-alkyl-N-arylamino, acyloxy, carbamoyloxy, N-alkylcarbamoyloxy, N-arylcarbamoyloxy, N,N-dialkylcarbamoyloxy, N,N-diarylcarbamoyloxy, N-alkyl-N-arylcarbamoyloxy, acylamino, N-alkylacylamino, N-arylacylamino, acyl, alkoxycarbonylamino, alkoxycarbonyl, aryloxycarbonyl, carbamoyl, N-alkylcarbamoyl, N,N-dialkylcarbamoyl, N-arylcarbamoyl, N,N-diarylcarbamoyl, N-alkyl-N-arylcarbamoyl, polyoxyalkylene groups, the above exemplified organic residue to which a polyoxyalkylene group bonds.

**10.** The method of claim 8 wherein $R_1$ and $R_2$ each represents hydrogen atom or an organic residue selected from linear or branched alkyl group having 1 to 10 carbon atoms; alkoxy group, alkoxycarbonyl group, N-alkylamino group, N,N-dialkylamino group, N-alkylcarbamoyl group, acyloxy group and acylamino group which have 1 to 10 carbon atoms; polyoxyalkylene group wherein the number of repeating unit is from 5 to 20; aryl group having 6 to 20 carbon atoms; and the aryl group to which a polyoxyalkylene group bonds with the number of repeating unit being from 5 to 20.

**11.** The method of claim 8 wherein r and r' each represents an integer of from 3 to 50, and s and s' each represents 0 or an integer of from 1 to 10.

**12.** The method of claim 6 wherein the anionic surfactant is selected from alkylbenzene sulfonic acid salts, alkylnaphthalene sulfonic acid salts, alkylsulfuric acid salts, alkyl sulfonic acid salts, and sulfosuccinate salts.

**13.** The method of claim 6 wherein the alkaline developing solution comprises the nonionic surfactant and/or the anionic surfactant in an amount of from 0.1 to 20% by weight.

**14.** The method of claim 1 wherein the alkaline developing solution further comprises an alkaline agent.

**15.** The method of claim 1 wherein the alkaline developing solution further comprises a chelating agent selected from polyphosphates, polyaminocarboxylic acids and salts thereof, and organophosphonic acids and salts thereof.

**16.** The method of claim 1 wherein the alkaline developing solution has a pH of from 9.0 to 12.0.

**17.** The method of claim 1 wherein (A) a radical generator is selected from the group consisting of onium salts, s-triazine compounds having a trihalomethyl group, peroxides, azo based polymerization initiators, azido compounds and borate salts.

**18.** The method of claim 17 wherein the onium salt is selected from the group consisting of the compounds represented by the formula (1), (2) or (3):

$$(1) \qquad Ar^{11}-\overset{+}{I}-Ar^{12}\ Z^{11-}$$

wherein $Ar^{11}$ and $Ar^{12}$ are each independently an aryl group having 20 carbon atoms or less, and $Z^{11-}$ represents a counter ion,

$$(2) \qquad Ar^{21}-\overset{+}{N}\equiv N\ Z^{21-}$$

wherein $Ar^{21}$ is an aryl group having 20 carbon atoms or less, and $Z^{21-}$ represents a counter ion,

(3) 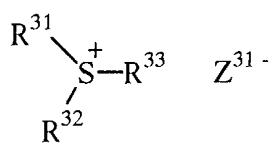

wherein $R^{31}$, $R^{32}$, and $R^{33}$ are each a hydrocarbon group having 20 carbon atoms or less, and $Z^{31-}$ represents a

counter ion.

**19.** The method of claim 1 wherein (B) a radical-polymerizable compound is selected from esters compounds of an unsaturated carboxylic acid and an aliphatic polyhydric alcohol, amide compounds of an unsaturated carboxylic acid and an aliphatic polyvalent amine, and urethane based addition-polymerizable compounds.

**20.** The method of claim 1 wherein (C) an infrared absorbing agent is selected from the group consisting of cyanine dyes, squarylium dyes, pyrylium salts, and nickel thiolate complexes.

**21.** The method of claim 20 wherein the cyanine dye is selected from the group consisting of the compounds represented by the formula:

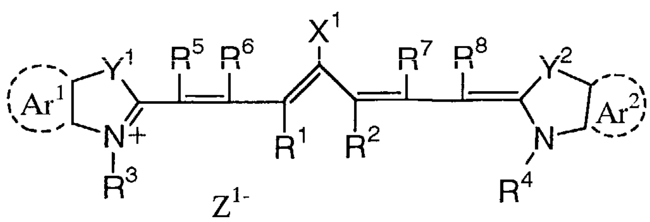

wherein $X^1$ represents a halogen atom, or $X^2$-$L^1$ or $NL^2L^3$, in which $X^2$ is oxygen atom or sulfur atom, $L^1$ is a hydrocarbon group having 1 to 12 carbon atoms, and $L^2$ and $L^3$ are each independently a hydrocarbon group having 1 to 12 carbon atoms; $R^1$ and $R^2$ are each independently a hydrocarbon group having 1 to 12 carbon atoms; $Ar^1$ and $Ar^2$ may be the same or different, and are each an aromatic hydrocarbon group which may have a substituent; $Y^1$ and $Y^2$, which may be the same or different, each represent sulfur atom or a dialkyl methylene group having 12 carbon atoms or less; $R^3$ and $R^4$, which may be the same or different, are each a hydrocarbon group having 20 carbon atoms or less which may have a substituent; $R^5$, $R^6$, $R^7$ and $R^8$, which may be the same or different, are each a hydrogen atom or a hydrocarbon group having 12 carbon atoms or less; $Z^{1-}$ represents a counter anion, but $Z^{1-}$ is not needed in the case where at least one of the groups represented by $R^1$ to $R^8$ has a sulfo group as a substituent.

European Patent Office

# EUROPEAN SEARCH REPORT

Application Number
EP 03 00 6248

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y,D | WO 00 48836 A (KODAK POLYCHROME GRAPHICS CO., LTD.) 24 August 2000 (2000-08-24)<br>* page 20 - page 21; example 1 * | 1-21 | B41M5/36<br>B41C1/10<br>G03F7/32 |
| Y | EP 1 120 246 A (FUJI PHOTO FILM CO.,LTD.) 1 August 2001 (2001-08-01)<br>* page 14, line 43 - line 58 *<br>* page 15, line 1 - line 44 *<br>* claim 6 * | 1-21 | |
| A | EP 0 716 347 A (FUJI PHOTO FILM CO., LTD.) 12 June 1996 (1996-06-12)<br>* page 4, line 20 - line 29 *<br>* page 18, line 23 - line 27 *<br>* page 20, line 17 - line 19 *<br>* claim 1 * | 1-21 | |
| A | US 4 579 811 A (L. SHELL ET AL.) 1 April 1986 (1986-04-01)<br>* column 9; example 8 * | 1-21 | |

TECHNICAL FIELDS SEARCHED (Int.Cl.7)
B41M
B41C
G03F

The present search report has been drawn up for all claims

| Place of search | Date of completion of the search | Examiner |
|---|---|---|
| THE HAGUE | 13 June 2003 | Dupart, J.-M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 03 00 6248

This annex lists the patent family membersrelating to the patent documents cited in the above-mentioned European search report.
The members are as contained in the European Patent Office EDP file on
The European Patent Office is in no way liable for these particulars which are merely given for the purpose of information.

13-06-2003

| Patent document cited in search report | Publication date | Patent family member(s) | Publication date |
|---|---|---|---|
| WO 0048836 A | 24-08-2000 | DE 19906823 A1 | 14-09-2000 |
| | | AU 3423900 A | 04-09-2000 |
| | | WO 0048836 A1 | 24-08-2000 |
| | | EP 1079972 A1 | 07-03-2001 |
| | | JP 2002537419 T | 05-11-2002 |
| EP 1120246 A | 01-08-2001 | JP 2001209172 A | 03-08-2001 |
| | | EP 1120246 A2 | 01-08-2001 |
| EP 0716347 A | 12-06-1996 | JP 3272174 B2 | 08-04-2002 |
| | | JP 8160631 A | 21-06-1996 |
| | | JP 8234447 A | 13-09-1996 |
| | | DE 69527494 D1 | 29-08-2002 |
| | | DE 69527494 T2 | 07-11-2002 |
| | | EP 0716347 A1 | 12-06-1996 |
| | | US 5837425 A | 17-11-1998 |
| US 4579811 A | 01-04-1986 | DE 3140186 A1 | 28-04-1983 |
| | | AT 24781 T | 15-01-1987 |
| | | AU 557455 B2 | 24-12-1986 |
| | | AU 8912382 A | 14-04-1983 |
| | | BR 8205902 A | 06-09-1983 |
| | | CA 1184803 A1 | 02-04-1985 |
| | | DE 3275026 D1 | 12-02-1987 |
| | | EP 0076984 A1 | 20-04-1983 |
| | | ES 8400611 A1 | 16-01-1984 |
| | | FI 823414 A | 10-04-1983 |
| | | JP 1796271 C | 28-10-1993 |
| | | JP 2044064 B | 02-10-1990 |
| | | JP 58076837 A | 10-05-1983 |
| | | ZA 8207372 A | 31-08-1983 |

EPO FORM P0459

For more details about this annex : see Official Journal of the European Patent Office, No. 12/82